(19) Europäisches Patentamt
European Patent Office
Office européen des brevets

(11) **EP 4 661 322 A1**

(12) **EUROPEAN PATENT APPLICATION**
published in accordance with Art. 153(4) EPC

(43) Date of publication:
**10.12.2025 Bulletin 2025/50**

(21) Application number: **23921778.9**

(22) Date of filing: **15.02.2023**

(51) International Patent Classification (IPC):
*H04L 1/00* (2006.01)

(52) Cooperative Patent Classification (CPC):
**H04L 1/00**

(86) International application number:
**PCT/CN2023/076267**

(87) International publication number:
**WO 2024/168615 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• **TONG, Jiajie
Shenzhen, Guangdong 518129 (CN)**

• **ZHANG, Huazi
Shenzhen, Guangdong 518129 (CN)**
• **WANG, Xianbin
Shenzhen, Guangdong 518129 (CN)**
• **WANG, Jun
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **RATE MATCHING METHOD, RATE DE-MATCHING METHOD AND COMMUNICATION APPARATUS**

(57) This application provides a rate matching method, a de-rate matching method, and a communication apparatus. The method includes: The communication apparatus determines a second position set based on a first position set. The first position set is an initial position set corresponding to a bit to be deleted during rate matching, and the second position set is a bit position set corresponding to an information bit in a to-be-encoded sequence. The communication apparatus performs rate matching on a first bit sequence to obtain a second bit sequence. The first bit sequence is obtained by performing channel encoding on the to-be-encoded sequence based on the second position set, the second bit sequence corresponds to a bit position other than a third position set in the first bit sequence, and a bit position in the third position set is a bit position obtained when a bit position in the first position set in the first bit sequence is converted in one or more of cyclic shift, mirror reversal, or segmented cyclic shift. The communication apparatus sends the second bit sequence. In this way, rate matching complexity can be reduced.

[FIG. 6]

600

S601: Determine a second bit position set based on a first bit position set, where the first bit position set is a bit position set corresponding to a to-be-deleted bit, and the second bit position set is a position set corresponding to an information bit sequence in a to-be-encoded bit sequence

S602: Perform channel encoding on the to-be-encoded bit sequence based on the second bit position set, to obtain a first bit sequence

S603: Perform rate matching on the first bit sequence, to obtain a second bit sequence, where the second bit sequence is a bit sequence corresponding to a bit position set other than a third bit position set in the first bit position set, and a bit position included in the third bit position set is a bit position obtained when a bit position included in the first bit position set in the first bit position is converted in one or more of cyclic shift, mirror reversal, or segmented cyclic shift

S604: Send the second bit sequence

**Description**

TECHNICAL FIELD

This application relates to the communication field, and more specifically, to a rate matching method, a de-rate matching method, and a communication apparatus.

BACKGROUND

Polar (Polar) code is a channel coding scheme that is proved to be capable of achieving a Shannon channel capacity, and has characteristics such as good performance and low complexity.

A code length of the polar code is usually a power of 2, but an actual transmission resource is not necessarily capable of carrying bits whose quantity is the power of 2. A communication apparatus at an encoding end needs to add or delete, through rate matching, some bits in a bit sequence obtained through encoding, to meet a requirement for transmitting the quantity of bits. When the code length of the polar code is greater than the quantity of bits that can be transmitted, the communication apparatus may delete the bits in the bit sequence through rate matching in a puncturing manner or a shortening manner based on an encoded target code rate. However, currently, positions of bits deleted in the puncturing manner and the shortening manner are inconsistent. The communication apparatus needs to determine and delete, based on different rate matching manners, a front-end bit or a back-end bit of the bit sequence in a sequence. Consequently, complexity of implementing rate matching by the communication apparatus and complexity of de-rate matching by a communication apparatus at a decoding end are high.

SUMMARY

Embodiments of this application provide a rate matching method, a de-rate matching method, and a communication apparatus, to improve flexibility of rate matching and reduce complexity of rate matching.

According to a first aspect, a rate matching method is provided. The method may be performed by a communication apparatus. The communication apparatus may be a communication device or a module (for example, a chip or a chip module) that is configured in (or used in) the communication device. The communication device may be a network device or a terminal device.

The method includes: The communication apparatus determines a second bit position set based on a first bit position set. The first bit position set is an initial position set corresponding to a bit to be deleted during rate matching, and the second bit position set is a position set corresponding to an information bit sequence in a to-be-encoded bit sequence. Then, the communication apparatus performs channel encoding on the to-be-encoded bit sequence based on the second bit position set, to obtain a first bit sequence. In addition, the communication apparatus performs rate matching on the first bit sequence to obtain a second bit sequence. The second bit sequence is a bit sequence corresponding to a bit position set other than a third bit position set in the first bit sequence, and a bit position included in the third bit position set is a bit position obtained when a bit position included in the first bit position set in the first bit sequence is converted in one or more of cyclic shift, mirror reversal, or segmented cyclic shift. The communication apparatus sends the second bit sequence.

According to the foregoing solution, a binding relationship between a position of a frozen bit in the to-be-encoded bit sequence and a position of a bit deleted during rate matching can be removed, thereby improving flexibility of rate matching.

With reference to the first aspect, in some implementations of the first aspect, the rate matching is in a shortening manner or a puncturing manner, and when a length of a bit sequence obtained through channel encoding is fixed and a length of a bit sequence obtained through rate matching is fixed, the shortening manner and the puncturing manner for the rate matching correspond to a same position of deleted bits.

According to the foregoing solution, when the length of the bit sequence obtained through channel encoding is fixed and the length of the bit sequence obtained through rate matching is fixed, through rate matching in the puncturing manner and the shortening manner, the communication apparatus may unify positions corresponding to bits deleted during rate matching, for example, the third bit position set is deleted. This reduces complexity of rate matching and reduces overheads of hardware implementation.

With reference to the first aspect, in some implementations of the first aspect, before the communication apparatus determines the second bit position set based on the first bit position set, the method further includes: The communication apparatus determines, based on a target code rate for the rate matching being a first code rate, to use a first rate matching manner. In addition, that the communication apparatus performs rate matching on the first bit sequence to obtain the second bit sequence includes: The communication apparatus performs rate matching on the first bit sequence in the first rate matching manner, to obtain the second bit sequence.

With reference to the first aspect, in some implementations of the first aspect, the method further includes: The communication apparatus determines, based on the target code rate for the rate matching being a second code rate, to use a second rate matching manner. The communication apparatus determines a fifth bit position set based on a fourth bit position set. The fifth bit position set is a position set corresponding to an information bit sequence in a third bit sequence, and the fourth bit position set is a position set corresponding to a to-be-deleted bit. Then, the communication apparatus performs channel encoding on the third bit sequence based on the fifth bit position set, to obtain a fourth bit sequence. The communication apparatus performs rate matching on the fourth bit sequence in the second rate matching manner, to obtain a fifth bit sequence. The fifth bit sequence is a bit sequence corresponding to a position set other than the fourth bit position set in the fourth bit sequence. The communication apparatus sends the fifth bit sequence.

According to the foregoing solution, the communication apparatus may use different rate matching manners based on different code rates of the rate matching. According to the rate matching solution provided in this application, the communication apparatus can unify positions of bits deleted in a same rate matching manner. For example, bits at a front end of a sequence are deleted, or bits at a back end of a sequence are deleted. This reduces complexity of rate matching and reduces overheads of hardware implementation.

In an implementation, the first code rate is less than or equal to a code rate threshold, the first rate matching manner is the puncturing manner, the second code rate is greater than the code rate threshold, and the second rate matching manner is the shortening manner.

In another implementation, the first code rate is greater than a code rate threshold, the first rate matching manner is the shortening manner, the second code rate is less than or equal to the code rate threshold, and the second rate matching manner is the puncturing manner.

With reference to the first aspect, in some implementations of the first aspect, the rate matching is in the puncturing manner, and a capacity of a bit position that is in the to-be-encoded bit sequence and that corresponds to each bit position included in the first bit position set is assumed to be 0.

With reference to the first aspect, in some implementations of the first aspect, the rate matching is in the shortening manner, and a capacity that is in the to-be-encoded bit sequence and that corresponds to each bit position included in the first bit position set is assumed to be a maximum capacity.

With reference to the first aspect, in some implementations of the first aspect, the rate matching is in the shortening manner, and the method further includes: The communication apparatus determines, based on the information bit sequence and a sixth bit sequence, a check bit sequence that is in the to-be-encoded bit sequence and that corresponds to the first bit position set. The sixth bit sequence is a predefined bit sequence corresponding to the third bit position set in the first bit sequence.

According to the foregoing solution, in the solution provided in this application, the check bit sequence that is in the to-be-encoded bit sequence and that is obtained when the rate matching in the shortening manner is used may be determined based on the information bit sequence and a bit sequence that corresponds to the bit position set (the third bit position set) and that is deleted during rate matching. Therefore, the rate matching solution that is in the shortening manner and that is provided in this application can be implemented.

With reference to the first aspect, in some implementations of the first aspect, the method further includes: The communication apparatus sends first information. The first information indicates the sixth bit sequence, and the sixth bit sequence is used for channel decoding.

According to the foregoing solution, when the rate matching in the shortening manner is used, the bit sequence that corresponds to the bit position set (the third bit position set) and that is deleted during rate matching may be determined by two communication parties through interaction, so that security of information transmission can be improved.

With reference to the first aspect, in some implementations of the first aspect, that the communication apparatus determines, based on the information bit sequence and the sixth bit sequence, the check bit sequence that is in the to-be-encoded bit sequence and that is in the first bit position set includes: The communication apparatus decodes a first soft information sequence based on the information bit sequence, to obtain a seventh bit sequence. A bit sequence that is in the seventh bit sequence and that corresponds to the first bit position set is the check bit sequence.

The first soft information sequence and the first bit sequence have a same sequence length, a soft information sequence that is in the first soft information sequence and that corresponds to the third bit position set is a soft information sequence of the sixth bit sequence, soft information corresponding to a bit position other than the third bit position set is 0, and the information bit sequence is a seventh bit sequence of a sequence that is in the seventh bit sequence and that corresponds to the second bit position set.

According to the foregoing solution, the communication apparatus may obtain, with low complexity by using the foregoing pseudo decoding process, the check bit sequence that is in the to-be-encoded bit sequence and that corresponds to the first bit position set.

According to a second aspect, a de-rate matching method is provided. The method may be performed by a communication apparatus. The communication apparatus may be a communication device or a module (for example, a chip or a chip module) that is configured in (or used in) the communication device. The communication device may be a network device or a terminal device.

The method includes: A communication apparatus performs de-rate matching on a first sequence to obtain a second sequence. A sequence corresponding to a third bit position set in the second sequence is a first preset sequence, and a bit position set other than the third bit position set in the second sequence corresponds to the first sequence. In addition, the communication apparatus performs channel decoding on the second sequence to obtain a third sequence; and determines a second bit position set based on a first bit position set. The second bit position set is a position set corresponding to an information bit sequence in the third sequence, and a bit position included in the first bit position set is a bit position obtained when a bit position included in the third bit position set in the third sequence is converted in one or more of cyclic shift, mirror reversal, or segmented cyclic shift. The communication apparatus obtains the information bit sequence in the third sequence based on the second bit position set.

With reference to the second aspect, in some implementations of the second aspect, the de-rate matching is de-rate matching corresponding to a shortening manner or a puncturing manner, and when a length of a sequence on which de-rate matching is to be performed is fixed, and a length of a sequence obtained through de-rate matching is fixed, preset sequences in sequences obtained through de-rate matching corresponding to the shortening manner and the puncturing manner correspond to a same bit position set.

With reference to the second aspect, in some implementations of the second aspect, before the communication apparatus performs de-rate matching on the first sequence to obtain the second sequence, the method further includes: The communication apparatus determines, based on a code rate of the first sequence being a first code rate, to use a first de-rate matching manner. In addition, that the communication apparatus performs de-rate matching on the first sequence to obtain the second sequence includes: The communication apparatus performs de-rate matching on the first sequence in the first de-rate matching manner, to obtain the second sequence.

With reference to the second aspect, in some implementations of the second aspect, the method further includes: The communication apparatus determines, based on a code rate of a fourth sequence being a second code rate, to use a second de-rate matching manner; and the communication apparatus performs de-rate matching on the fourth sequence in the second de-rate matching manner, to obtain a fifth sequence. A sequence that is in the fifth sequence and that corresponds to a fourth bit position set is a second preset sequence, and a bit position set other than the fourth bit position set in the fifth sequence corresponds to the fourth sequence. Then, the communication apparatus performs channel decoding on the fifth sequence to obtain a sixth sequence, and determines a fifth bit position set based on the fourth bit position set. The fifth bit position set is a position set corresponding to an information bit sequence in the sixth sequence. The communication apparatus obtains the information bit sequence in the sixth sequence based on the fifth bit position set.

With reference to the second aspect, in some implementations of the second aspect, the first code rate is less than or equal to a code rate threshold, the first de-rate matching manner is a de-rate matching manner corresponding to the puncturing manner, the second code rate is greater than the code rate threshold, and the second de-rate matching manner is a de-rate matching manner corresponding to the shortening manner.

With reference to the second aspect, in some implementations of the second aspect, the first code rate is greater than a code rate threshold, the first de-rate matching manner is a de-rate matching manner corresponding to the shortening manner, the second code rate is less than or equal to the code rate threshold, and the second de-rate matching manner is a de-rate matching manner corresponding to the puncturing manner.

With reference to the second aspect, in some implementations of the second aspect, the method further includes: The communication apparatus receives first information. The first information indicates a sixth bit sequence. The first preset sequence is a log-likelihood ratio LLR sequence corresponding to the sixth bit sequence.

According to a third aspect, a communication apparatus is provided. In a design, the apparatus may include modules that are in a one-to-one correspondence with the methods/operations/steps/actions described in the first aspect. The modules may be implemented by a hardware circuit, software, or a combination of a hardware circuit and software. In a design, the apparatus includes a processing unit and a transceiver unit. The processing unit is configured to determine a second bit position set based on a first bit position set. The first bit position set is an initial position set corresponding to a bit to be deleted during rate matching, and the second bit position set is a position set corresponding to an information bit sequence in a to-be-encoded bit sequence. The processing unit is further configured to: perform, based on the second bit position set, channel encoding on the to-be-encoded bit sequence to obtain a first bit sequence; and perform rate matching on the first bit sequence to obtain a second bit sequence. The second bit sequence is a bit sequence corresponding to a bit position set other than a third bit position set in the first bit sequence, and a bit position included in the third bit position set is a bit position obtained when a bit position included in the first bit position set in the first bit sequence is converted in one or more of cyclic shift, mirror reversal, or segmented cyclic shift. The transceiver unit is configured to send the second bit sequence.

With reference to the third aspect, in some implementations of the third aspect, before determining the second bit position set based on the first bit position set, the processing unit is further configured to determine, based on a target code rate for the rate matching being a first code rate, to use a first rate matching manner. The processing unit is specifically configured to perform rate matching on the first bit sequence in the first rate matching manner, to obtain the second bit sequence.

With reference to the third aspect, in some implementations of the third aspect, the processing unit is further configured to: determine, based on the target code rate for the rate matching being a second code rate, to use a second rate matching manner; and determine a fifth bit position set based on a fourth bit position set. The fifth bit position set is a position set corresponding to an information bit sequence in a third bit sequence, and the fourth bit position set is a position set corresponding to a to-be-deleted bit. The processing unit is further configured to: perform channel encoding on the third bit sequence based on the fifth bit position set, to obtain a fourth bit sequence; and perform rate matching on the fourth bit sequence in the second rate matching manner, to obtain a fifth bit sequence. The fifth bit sequence is a bit sequence corresponding to a position set other than the fourth bit position set in the fourth bit sequence. The transceiver unit is further configured to send the fifth bit sequence.

With reference to the third aspect, in some implementations of the third aspect, the rate matching is in a shortening manner, and the method further includes: The processing unit is further configured to: determine, based on the information bit sequence and a sixth bit sequence, a check bit sequence that is in the to-be-encoded bit sequence and that corresponds to the first bit position set. The sixth bit sequence is a predefined bit sequence corresponding to the third bit position set in the first bit sequence.

With reference to the third aspect, in some implementations of the third aspect, the transceiver unit is further configured to send first information. The first information indicates the sixth bit sequence, and the sixth bit sequence is used for channel decoding.

With reference to the third aspect, in some implementations of the third aspect, the processing unit is specifically configured to decode a first soft information sequence based on the information bit sequence, to obtain a seventh bit sequence. A bit sequence that is in the seventh bit sequence and that corresponds to the first bit position set is the check bit sequence. The first soft information sequence and the first bit sequence have a same sequence length, a soft information sequence that is in the first soft information sequence and that corresponds to the third bit position set is a soft information sequence of the sixth bit sequence, soft information corresponding to a bit position other than the third bit position set is 0, and the information bit sequence is a seventh bit sequence of a sequence that is in the seventh bit sequence and that corresponds to the second bit position set.

According to a fourth aspect, a communication apparatus is provided. In a design, the apparatus may include modules that are in a one-to-one correspondence with the methods/operations/steps/actions described in the second aspect. The modules may be implemented by a hardware circuit, software, or a combination of a hardware circuit and software. In a design, the apparatus includes a processing unit and a transceiver unit. The transceiver unit is configured to receive a first sequence. The processing unit is configured to perform de-rate matching on a first sequence to obtain a second sequence. A sequence corresponding to a third bit position set in the second sequence is a first preset sequence, and a bit position set other than the third bit position set in the second sequence corresponds to the first sequence. In addition, the processing unit is further configured to perform channel decoding on the second sequence to obtain a third sequence; and determine a second bit position set based on a first bit position set. The second bit position set is a position set corresponding to an information bit sequence in the third sequence, and a bit position included in the first bit position set is a bit position obtained when a bit position included in the third bit position set in the third sequence is converted in one or more of cyclic shift, mirror reversal, or segmented cyclic shift. The processing unit is further configured to obtain the information bit sequence in the third sequence based on the second bit position set.

With reference to the fourth aspect, in some implementations of the fourth aspect, before performing de-rate matching on the first sequence to obtain the second sequence, the processing unit is further configured to determine, based on a code rate of the first sequence being a first code rate, to use a first de-rate matching manner. The processing unit is specifically configured to perform de-rate matching on the first sequence in the first de-rate matching manner, to obtain the second sequence.

With reference to the fourth aspect, in some implementations of the fourth aspect, the processing unit is specifically configured to: determine, based on a code rate of a fourth sequence being a second code rate, to use a second de-rate matching manner; and perform de-rate matching on the fourth sequence in the second de-rate matching manner, to obtain a fifth sequence. A sequence that is in the fifth sequence and that corresponds to a fourth bit position set is a second preset sequence, and a bit position set other than the fourth bit position set in the fifth sequence corresponds to the fourth sequence. Then, the processing unit is specifically configured to: perform channel decoding on the fifth sequence to obtain a sixth sequence; and determine a fifth bit position set based on the fourth bit position set. The fifth bit position set is a position set corresponding to an information bit sequence in the sixth sequence. The processing unit is further configured to obtain the information bit sequence in the sixth sequence based on the fifth bit position set.

With reference to the fourth aspect, in some implementations of the fourth aspect, the transceiver unit is further configured to receive first information. The first information indicates a sixth bit sequence. The first preset sequence is a log-likelihood ratio LLR sequence corresponding to the sixth bit sequence.

According to a fifth aspect, a communication apparatus is provided, including a processor. The processor may implement the method in any one of the first aspect and the possible implementations of the first aspect, and/or may implement the method in any one of the second aspect and the possible implementations of the second aspect.

Optionally, the communication apparatus further includes a memory. The processor may be configured to execute instructions in the memory, to implement the method in any one of the first aspect and the possible implementations of the first aspect and/or the method in any one of the second aspect and the possible implementations of the second aspect. In an implementation, the processor is integrated with the memory. In another implementation, the processor includes the memory.

Optionally, the communication apparatus further includes a communication interface, and the processor is coupled to the communication interface. In this embodiment of this application, the communication interface may be a transceiver, a pin, a circuit, a bus, a module, or a communication interface of another type. This is not limited.

In an implementation, the communication apparatus is a communication device. When the communication apparatus is the communication device, the communication interface may be a transceiver or an input/output interface.

In another implementation, the communication apparatus is a chip configured in the communication device. When the communication apparatus is the chip configured in the communication device, the communication interface may be an input/output interface.

Optionally, the transceiver may be a transceiver circuit. Optionally, the input/output interface may be an input/output circuit.

According to a sixth aspect, an embodiment of this application provides a communication apparatus, including a logic circuit and a communication interface. The logic circuit is configured to process to-be-processed information to obtain processed information, and the communication interface is configured to obtain the to-be-processed information and/or output the processed information, so that the communication apparatus performs the method according to any one of the first aspect and the possible implementations of the first aspect, and/or perform the method according to any one of the second aspect and the possible implementations of the second aspect. Optionally, the communication interface includes an input interface and an output interface.

In an implementation, the logic circuit is configured to determine a second bit position set based on a first bit position set. The first bit position set is an initial position set corresponding to a bit to be deleted during rate matching, and the second bit position set is a position set corresponding to an information bit sequence in a to-be-encoded bit sequence. The logic circuit is further configured to: perform, based on the second bit position set, channel encoding on the to-be-encoded bit sequence to obtain a first bit sequence; and perform rate matching on the first bit sequence to obtain a second bit sequence. The second bit sequence is a bit sequence corresponding to a bit position set other than a third bit position set in the first bit sequence, and a bit position included in the third bit position set is a bit position obtained when a bit position included in the first bit position set in the first bit sequence is converted in one or more of cyclic shift, mirror reversal, or segmented cyclic shift. The communication interface is configured to send the second bit sequence.

In another implementation, the communication interface is configured to receive a first sequence. The logic circuit is further configured to: perform de-rate matching on the first sequence to obtain a second sequence, where a sequence corresponding to a third bit position set in the second sequence is a first preset sequence, and a bit position set other than the third bit position set in the second sequence corresponds to the first sequence; and perform channel decoding on the second sequence to obtain a third sequence. The logic circuit is further configured to: determine a second bit position set based on a first bit position set. The second bit position set is a position set corresponding to an information bit sequence in the third sequence, and a bit position included in the first bit position set is a bit position obtained when a bit position included in the third bit position set in the third sequence is converted in one or more of cyclic shift, mirror reversal, or segmented cyclic shift. The logic circuit is further configured to obtain the information bit sequence in the third sequence based on the second bit position set.

According to a seventh aspect, a processor is provided, including an input circuit, an output circuit, and a processing circuit. The processing circuit is configured to receive a signal through the input circuit, and transmit a signal through the output circuit, so that the processor performs the method according to any one of the first aspect and the possible implementations of the first aspect, and/or performs the method according to any one of the second aspect and the possible implementations of the second aspect.

In a specific implementation process, the processor may be one or more chips, the input circuit may be an input pin, the output circuit may be an output pin, and the processing circuit may be a transistor, a gate circuit, a trigger, various logic circuits, or the like. An input signal received by the input circuit may be received and input by, for example, but not limited to, a receiver, a signal output by the output circuit may be output to, for example, but not limited to, a transmitter and transmitted by the transmitter, and the input circuit and the output circuit may be a same circuit. The circuit is used as the input circuit and the output circuit at different moments. Specific implementations of the processor and the various circuits are not limited in this embodiment of this application.

According to an eighth aspect, a computer program product is provided. The computer program product includes a computer program (which may also be referred to as code or instructions). When the computer program is run, the computer is enabled to perform the method according to any one of the first aspect or the second aspect and the possible implementations of the first aspect or the second aspect.

According to a ninth aspect, a computer-readable storage medium is provided. The computer-readable storage medium stores a computer program (which may also be referred to as code or instructions). When the computer-readable storage medium is run on a computer, the computer is enabled to perform the method according to any one of the first aspect or the second aspect and the possible implementations of the first aspect or the second aspect.

According to a tenth aspect, a communication device is provided, including the foregoing communication apparatus for performing the method according to any one of the first aspect and the possible implementations of the first aspect and/or the foregoing communication apparatus for performing the method according to any one of the second aspect and the possible implementations of the second aspect.

For example, the communication device includes a sending apparatus and/or a receiving apparatus. The sending apparatus is configured to perform the method according to any one of the first aspect and the possible implementations of the first aspect, and the receiving apparatus is configured to perform the method according to any one of the second aspect and the possible implementations of the second aspect. In an implementation, the sending apparatus and the receiving apparatus may be integrated as a transceiver apparatus of the communication device.

According to an eleventh aspect, a communication system is provided, including the foregoing communication apparatus for performing the method according to any one of the first aspect and the possible implementations of the first aspect and the foregoing communication apparatus for performing the method according to any one of the second aspect and the possible implementations of the second aspect.

BRIEF DESCRIPTION OF DRAWINGS

FIG. 1 is a block diagram of a communication system applicable to an embodiment of this application;
FIG. 2 is a schematic flowchart of a physical layer information processing process according to this application;
FIG. 3 is a diagram of a polar code encoding process according to this application;
FIG. 3a is a diagram of a polar code decoding unit according to this application;
FIG. 4 is a diagram of rate matching according to this application;
FIG. 5 is a diagram of a sequence shift manner according to this application;
FIG. 6 is a schematic flowchart of a rate matching method according to this application;
FIG. 7 is a diagram of a correspondence between an initial bit position set and a frozen bit position set according to this application;
FIG. 8 is another diagram of a correspondence between an initial bit position set and a frozen bit position set according to this application;
FIG. 9 is a diagram of a third bit position set according to this application;
FIG. 10 is a diagram of rate matching in a shortening manner according to this application;
FIG. 11 is a diagram of determining a check bit sequence according to this application;
FIG. 12 is another diagram of rate matching in a shortening manner according to this application;
FIG. 13 is a diagram of rate matching in a puncturing manner according to this application;
FIG. 14 is another schematic flowchart of a de-rate matching method according to this application;
FIG. 15 is a diagram of a structure of a communication apparatus according to this application; and
FIG. 16 is another diagram of a structure of a communication apparatus according to this application.

DESCRIPTION OF EMBODIMENTS

The following describes the technical solutions in this application with reference to the accompanying drawings.
In embodiments of this application, "/" may indicate an "or" relationship between associated objects. For example, A/B may indicate A or B. "and/or" may indicate that there are three relationships between associated objects. For example, A and/or B may indicate the following three cases: Only A exists, both A and B exist, and only B exists, where A and B may be singular or plural. For ease of describing the technical solutions in embodiments of this application, terms such as "first" and "second" may be used for differentiation in embodiments of this application. The words such as "first" and "second" do not limit a quantity and an execution sequence, and the words such as "first" and "second" do not limit a definite difference. In embodiments of this application, the word such as "example" or "for example" is used to represent an example, evidence, or a description. Any embodiment or design solution described as "example" or "for example" should not be explained as being more preferred or having more advantages than another embodiment or design solution. A word such as "example" or "for example" is used to present a related concept in a specific manner for ease of understanding. In embodiments of this application, "at least one (type)" may alternatively be described as "one (type) or more (types)", and "a plurality of (types)" may be two (types), three (types), four (types), or more (types). This is not limited in embodiments of this application.
The technical solutions in embodiments of this application may be applied to various communication systems, for example, a long term evolution (long term evolution, LTE) system, a 5G system, a new radio (new radio, NR), a non-terrestrial network (non-terrestrial network, NTN), and a future communication system like a 6th generation mobile communication system. This is not limited in this application.

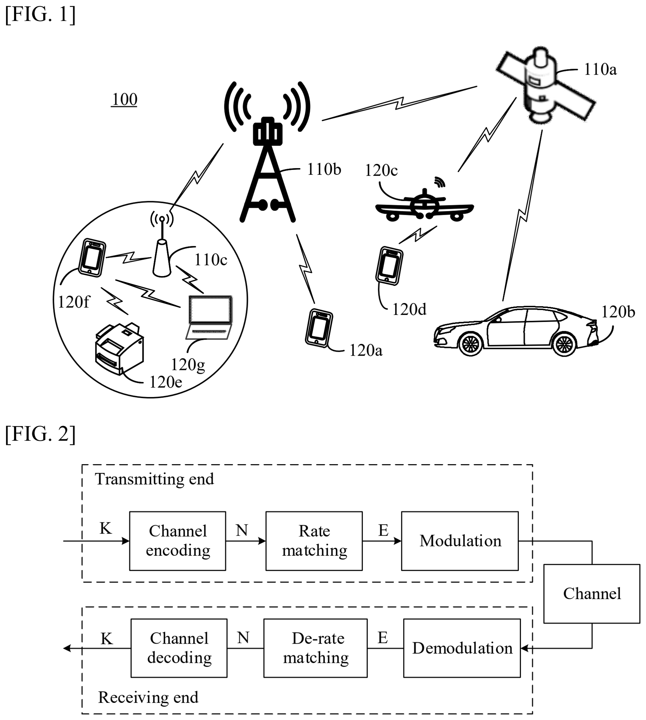

FIG. 1 is a diagram of an architecture of a communication system 100 applicable to an embodiment of this application. As shown in FIG. 1, the communication system 100 may include at least one network device (for example, 110a, 110b, and 110c in FIG. 1), and may further include at least one terminal device (for example, 120a to 120g in FIG. 1). Network devices may be connected to each other in a wired or wireless manner. FIG. 1 is merely a diagram. The communication system may further include another network device, for example, may further include a wireless relay device and a wireless backhaul device. Both the first communication apparatus and the second communication apparatus provided in the embodiments of this application may be network devices or terminal devices, or the first communication apparatus and the second communication apparatus may be one of a network device and a terminal device respectively.

The communication apparatus (for example, the first communication apparatus and/or the second communication apparatus) provided in embodiments of this application may be a network device, or a module (for example, a chip or a chip system) configured in the network device. A network device may be an access network device, for example, a base station (base station), a NodeB (NodeB), an evolved NodeB (evolved NodeB, eNodeB, or eNB), a transmission reception point (transmission reception point, TRP), a next generation NodeB (next generation NodeB, gNB) in a 5th generation (5th generation, 5G) mobile communication system, an access network device in an open radio access network (open radio access network, O-RAN, or open RAN), a next generation base station in a 6th generation (6th generation, 6G) mobile communication system, a base station in a future mobile communication system, or an access node in a wireless fidelity (wireless fidelity, Wi-Fi) system. The network device may be a satellite (for example, 110a in FIG. 1) or may be a macro base station (for example, 110b in FIG. 1). Alternatively, the access network device may be a micro base station or an indoor base station (for example, 110c in FIG. 1), or may be a relay node or a donor node. A specific technology and a specific device form that are used by the network device are not limited in this application. In embodiments of this application, some or all functions of the network device may be on a non-terrestrial network (non-terrestrial network, NTN) platform (where the NTN platform includes but is not limited to a satellite, an unmanned aircraft system (unmanned aircraft system, UAS), a high altitude communication platform (high altitude platform station, HAPS), and the like), or some or all functions of the network device are on the ground, and the NTN platform is responsible for forwarding a signal between the UE and the access network device.

Alternatively, the communication apparatus provided in embodiments of this application may be a module or unit that completes some functions of the network device, for example, may be a central unit (central unit, CU), a distributed unit (distributed unit, DU), a central unit control plane (CU control plane, CU-CP) module, or a central unit user plane (CU user plane, CU-UP) module. In some other deployments, the communication apparatus may alternatively be an antenna unit (radio unit, RU) or the like. In some other deployments, the communication apparatus may alternatively be an open radio access network (open radio access network, ORAN) architecture or the like. A specific type of the communication apparatus is not limited in this application. For example, when the communication apparatus is of the ORAN architecture, the communication apparatus shown in embodiments of this application may be an access network device in an ORAN, a module in the access network device, or the like. In an ORAN system, a CU may also be referred to as an open (open, O)-CU, a DU may also be referred to as an O-DU, a CU-DU may also be referred to as an O-CU-DU, a CU-UP may also be referred to as an O-CU-UP, and an RU may also be referred to as an O-RU.

The communication apparatus (for example, the first communication apparatus and/or the second communication apparatus) provided in embodiments of this application may be a terminal device, or a module (for example, a chip or a chip system) configured in the terminal device. The terminal device may also be referred to as a terminal, and includes but is not limited to user equipment (user equipment, UE), a mobile station, a mobile terminal, or the like. The terminal device may be widely used in various scenarios for communication. For example, the scenario includes but is not limited to at least one of the following scenarios: enhanced mobile broadband (enhanced mobile broadband, eMBB), ultra-reliable low-latency communication (ultra-reliable low-latency communication, URLLC), massive machine-type communications (massive machine-type communications, mMTC), device-to-device (device-to-device, D2D) communication, vehicle to everything (vehicle to everything, V2X) communication, machine-type communication (machine-type communication, MTC), an internet of things (internet of things, IoT), virtual reality, augmented reality, industrial control, autonomous driving, telemedicine, a smart grid, smart furniture, smart office, smart wearable, smart transportation, a smart city, or the like. The terminal device may be a mobile phone (for example, mobile phones 120a, 120d, and 120f in FIG. 1), a tablet computer, a computer (for example, a computer 120g in FIG. 1) having a wireless transceiver function, a wearable device, a vehicle (for example, 120b in FIG. 1), an unmanned aerial vehicle, a helicopter, an airplane (for example, 120c in FIG. 1), a ship, a robot, a mechanical arm, a smart home device (for example, a printer 120e in FIG. 1), or the like. A specific technology and a specific device form used by the terminal device are not limited in this application.

The first communication apparatus provided in embodiments of this application may be referred to as a sending apparatus, and the second communication apparatus may be referred to as a receiving apparatus. In an implementation, the first communication apparatus and the second communication apparatus may be different communication devices or communication modules (such as chips or chip systems) configured in different communication devices. In another implementation, the communication device or the communication module may have both a function of the first communication apparatus and a function of the second communication apparatus.

During specific implementation, a receiving operation of the communication apparatus described in embodiments may be an input operation, a sending operation may be an output operation, a signal (for example, data/signaling/a signal) received from the second communication apparatus may be indirectly obtained through transfer by another apparatus, and a signal sent to the second communication apparatus may be indirectly obtained through transfer by another apparatus to the second communication apparatus. This is not limited in this application.

To better understand embodiments of this application, the following describes related technologies and terms in embodiments of this application.

1. Physical layer processing process

FIG. 2 is a schematic flowchart of a physical layer information processing process. A transmitting end performs channel encoding on an information bit sequence whose length is K. The information bit sequence may include a communication information bit and a cyclic redundancy check (cyclic redundancy check, CRC) bit that need to be sent by the transmitting end to a receiving end, or the bit sequence whose length is K may include only the communication information bit. Channel encoding is performed on the information bit sequence to obtain an encoded bit sequence whose code length is N. The transmitting end may determine, based on a size of a transmission resource, that a quantity of bits that can be actually sent is E. If E is not equal to N, the transmitting end needs to perform rate matching on the encoded bit sequence, to obtain a bit sequence whose length is E. The transmitting end modulates the bit sequence whose length is E, and then sends a modulated bit sequence to a channel. Correspondingly, after receiving a modulated symbol from the transmitting end over the channel, the receiving end performs demodulation, de-rate matching, and channel decoding, to restore the information bit sequence. It should be understood that the physical layer information processing process may include but is not limited to the modules shown in FIG. 2. For example, if the transmitting end uses an orthogonal frequency division multiplexing (orthogonal frequency division multiplexing, OFDM) technology, modulation shown in FIG. 2 may be digital modulation. After the digital modulation, a resource mapping module may be further included. The resource mapping module separately maps a digital modulated symbol to mutually orthogonal subcarriers in transmission bandwidth, and then sends a digital modulated symbol obtained through OFDM modulation to the channel. Correspondingly, after performing OFDM demodulation, the receiving end obtains a modulated symbol through resource demapping, and then performs digital demodulation. This is not limited in this application.

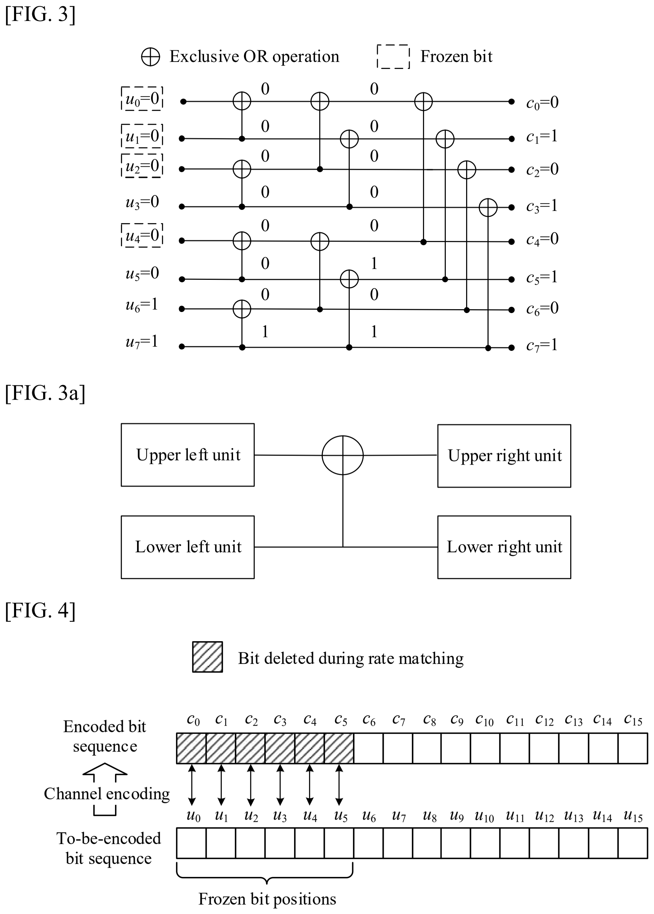

A channel coding scheme of polar code may be used for channel coding. A code length N of the polar code is a power of 2, that is, $N=2^n$, n is a positive integer, and a value of n is determined based on a length K of a bit sequence on which channel encoding needs to be performed and the quantity E of bits that can be actually sent. A to-be-encoded bit sequence of channel encoding includes N bits, and the N bits may be separately information bits and frozen bits in an order of reliability of subchannels corresponding to the N bits. For example, FIG. 3 is a diagram of encoding polar code whose code length is N=8. Bit positions 3, 5, 6, and 7 corresponding to $u_3$, $u_5$, $u_6$, and $u_7$ in 8 bits of the to-be-encoded bit sequence u are four bit positions with highest reliability. The four bit positions may be used as bit positions corresponding to information bits. For example, the information bits are: $u_3=0$, $u_5=0$, $u_6=1$, and $u_7=1$, that is, an information bit sequence is 0011. Bit positions 0, 1, 2, and 4 corresponding to $u_0$, $u_1$, $u_2$, and $u_4$ are four bit positions with low reliability. The four bit positions may be used as bit positions corresponding to frozen bits. Generally, the frozen bits are 0, $u_0=0$, $u_1=0$, $u_2=0$, and $u_4=0$, that is, a frozen bit sequence is 0000. After channel encoding is performed on the to-be-encoded bit sequence u: $[u_0u_1u_2u_3u_4u_5u_6u_7]$=00000011 in the channel encoding scheme shown in FIG. 3:

An encoded bit sequence c $[c_0c_1c_2c_3c_4c_5c_6c_7]$=01010101 is obtained.

The code length N of the polar code is a power of 2, and the quantity E of bits that can be actually sent is not necessarily a power of 2. Therefore, if E is not equal to N, the transmitting end needs to perform rate matching on the encoded bit sequence to obtain a bit sequence whose length is E. For example, in an existing NR standard, when E is greater than N, the transmitting end repeatedly adds E-N bits in the encoded bit sequence to obtain the bit sequence whose length is E. When E is less than N, the transmitting end determines, based on a code rate K/E, to use a puncturing manner or a shortening manner. If an encoding rate (a code rate for short) K/E≤7/16, the transmitting end uses the puncturing manner and sends last E bits in the N bits in the encoded bit sequence, that is, deletes first N-E bits in the encoded bit sequence. If the code rate K/E>7/16, the transmitting end uses the shortening manner and sends first E bits in the N bits in the encoded bit sequence, that is, deletes last N-E bits in the encoded bit sequence. A prerequisite for this implementation is that a position of a deleted bit corresponds to a frozen bit in the to-be-encoded bit sequence. To be specific, for the puncturing manner, first N-E bits in the to-be-encoded bit sequence are frozen bits, and for the shortening manner, last N-E bits in the to-be-encoded bit sequence are frozen bits. Optionally, if the transmitting end further performs block interleaving on the encoded bit sequence, the transmitting end performs rate matching in the foregoing manner on a bit sequence obtained through block interleaving.

2. Polar code decoding

An f-function and a g-function are two basic operations of the polar code. Inputs of the f-function are $L_0$ and $L_1$, and an output is $L_{out}$. For example, the f-function may be represented as follows:

$$L_{out1} = f(L_0, L_1) = sign(L_0 \cdot L_1) \cdot min(|L_0|, |L_1|).$$

Herein, sign is a sign determining operation. As shown in a decoding unit in FIG. 3a, a decoder side performs decoding on each decoding unit from right to left, and the inputs $L_0$ and $L_1$ of the f-function are values of two logical correlation units at a right end. If a product of $L_0$ and $L_1$ is a positive number, $sign(L_0 \cdot L_1)$ is a positive sign, and the output $L_{out}$ is a positive number. If a product of $L_0$ and $L_1$ is a negative number, $sign(L_0 \cdot L_1)$ is a negative sign, and the output $L_{out}$ is a negative number. A value of $L_{out}$ is equal to a minimum absolute value of $L_0$ and $L_1$, and the output $L_{out}$ of the f-function is a value of an upper left unit.

Inputs of the g-function are $L_0$ and $L_1$, and an output is $L_{out2}$. For example, the g-function may be represented as follows:

$$L_{out2} = g(L_0, L_1, b) = (-1)^b \cdot L_0 + L_1.$$

The decoding unit shown in FIG. 3a is further used as an example. $L_0$ and $L_1$ are the values of the two logical correlation units at the right end, and b is determined based on an upper left unit. If the upper left unit is of an LLR value, when a value of the upper left unit is greater than 0, b=0; or when a value of the upper-left unit is less than 0, b=1. If the upper left unit is a bit, when a value of the upper left unit is 0, b=0; or when a value of the upper left unit is 1, b=1.

The decoding end may implement a polar code decoding algorithm based on the f-function and the g-function. Currently, the polar code decoding algorithm is mainly a serial cancellation decoding algorithm. The serial cancellation decoding algorithm means that the decoding end performs decoding bit by bit based on a natural time sequence design of the polar code. Currently, main serial cancellation decoding algorithms include successive cancellation (successive cancellation, SC) decoding, successive cancellation list (successive cancellation list, SCL) decoding, CRC-aided successive cancellation list (CRC-aided successive cancellation list, CA-SCL) decoding, and the like. This is not limited in this application.

3. Sequence position change relationship

a. Cyclic shift

For two pieces of polar code A and B whose code lengths are N, LLR sequences corresponding to the two pieces of polar code A and B at the decoder side are: $L = \{l_0\,l_1\,l_2 \ldots l_{N-2}\,l_{N-1}\}$ and $L' = \{l'_0\,l'_1\,l'_2, \ldots l'_{N-2}\,l'_{N-1}\}$. If $l_i = l'_{N-1-i}$, where $i \in [0: N - 1]$, the LLR sequences of the two pieces of polar code A and B are mirror-symmetric. Therefore, subnode distribution $L_{left}$ obtained through a leftward F operation on L is also mirror-symmetric to subnode distribution $L'_{left}$ obtained through a leftward F operation on L', and subnode distribution $L_{right}$ obtained through a rightward G operation on L is also mirror-symmetric to subnode distribution $L'_{right}$ obtained through a rightward G operation on L'. It should be noted that, when $l_0 = l_1 = l_2 = \cdots l_{N-2} = l_{N-1}$, L is mirror-symmetric. Therefore, on two decoding trees whose root nodes are mirror-symmetric, an LLR of each node is mirrored, and a leaf node is also mirrored. Because a leaf node has only one LLR, LLRs of two leaf nodes corresponding to same positions are also the same. Therefore, if the two pieces of polar code A and B whose code lengths are equal are mirror-symmetric, capacities of subchannels corresponding to bit positions are consistent after channel decoding, that is, probabilities that the bit positions are correctly decoded are the same.

b. Mirror reversal

For two pieces of polar code A and B whose code lengths are N, LLR sequences corresponding to the two pieces of polar code A and B at the decoder side are: $L = \{l_0\,l_1\,l_2 \ldots l_{N-2}\,l_{N-1}\}$ and $L' = \{l'_0\,l'_1\,l'_2, \ldots l'_{N-2}\,l'_{N-1}\}$. If $l_i = l'_{mod(i+x,N)}$, where $i \in [0: N - 1]$, L' is a sequence obtained through rightward cyclic translation on L by x elements. When L' is obtained through rightward cyclic translation on L by x elements, subnode distribution $L'_{left}$ obtained through a leftward F operation on L' is obtained through rightward mod(i + x, N/2) cyclic translation on subnode distribution $L_{left}$ obtained through a leftward F operation on L, and subnode distribution $L'_{right}$ obtained through a rightward G operation on L' is obtained through rightward mod(i + x, N/2) cyclic translation on subnode distribution $L_{right}$ obtained through a rightward G operation on L. It should be noted that, when $l_0 = l_1 = l_2 = \cdots l_{N-2} = l_{N-1}$, rightward cyclic translation is performed on L by x elements, where x is a positive integer. Therefore, on two decoding trees obtained after a root node on which cyclic translation is performed, cyclic translation is performed on LLR distribution of each node. Cyclic translation is also performed on a leaf node. Because the leaf node has only one LLR, LLR distribution of two leaf nodes corresponding to same positions is also the same. Therefore, if cyclic translation is performed on the two pieces of polar code A and B, capacities of subchannels corresponding to bit positions after channel decoding are consistent.

c. Segmented cyclic shift

For two pieces of polar code A and B whose code lengths are N, LLR sequences corresponding to the two pieces of polar code A and B at the decoder side are: L = {$l_0\ l_1\ l_2 \ldots l_{N-2}\ l_{N-1}$} and $L' = \{l'_0\ l'_1\ l'_2, \ldots l'_{N-2}\ l'_{N-1}\}$ , L and L' are divided into M sections in a same manner, and M=$2^m$. In addition, cyclic translation is performed on each section of sequence by x elements in the sequence. In this case, L' is a sequence obtained through rightward cyclic translation on L by x elements in M segments, and capacities of subchannels corresponding to bit positions after channel decoding are consistent.

In conclusion, for the two pieces of polar code A and B whose code lengths are N, if capacity distribution of subchannels of B before decoding may be obtained after capacity distribution of subchannels of A before decoding is processed by performing one or more of cyclic shift, mirror reversal, or segmented cyclic shift, capacity distribution of subchannels corresponding to decoded bit sequences obtained after decoding of the polar code A and B is consistent. Correspondingly, capacity distribution of corresponding subchannels in to-be-encoded bit sequences that respectively correspond to A and B before encoding is consistent.

In the polar code, when the code rate is high, rate matching performance in the shortening manner is good. When the code rate is low, there is a performance loss in the shortening manner, and rate matching in the puncturing manner can improve performance. However, positions of bits deleted in the puncturing manner and the shortening manner are inconsistent. Therefore, the communication apparatus needs to determine and delete first N-E bits or last N-E bits of the sequence based on different rate matching manners. This increases complexity of implementing rate matching and de-rate matching by the communication apparatus, and increases overheads of hardware implementation.

According to this application, if the foregoing two sequences can be obtained from each other through processing of one or more of cyclic shift, mirror reversal, or segmented cyclic shift, capacity distribution of subchannels corresponding to the two sequences after decoding is consistent. A binding relationship between a position of a frozen bit in the to-be-encoded bit sequence and a position of a bit deleted during rate matching can be removed, thereby improving flexibility of rate matching.

For example, for the polar code whose code length is N=16, the communication apparatus may determine, based on the size of the transmission resource, the quantity E=10 of bits that can be actually sent, and the communication apparatus needs to delete, through rate matching after channel encoding, N-E=6 bits in the sequence on which rate matching is to be performed. As shown in FIG. 4, an encoded bit sequence obtained through channel encoding is used as a sequence on which rate matching is to be performed. The rate matching in the puncturing manner is used as an example. During rate matching, the communication apparatus needs to delete bits corresponding to bit positions in a bit position set $X_1$ in the encoded bit sequence. For example, the bit position set $X_1$ includes a bit position 0 to a bit position 5, and the communication apparatus deletes bits $c_0$ to $c_5$ in the encoded bit sequence in a rate matching process. Based on this, the communication apparatus may determine, before channel encoding, bits $u_0$ to $u_5$ corresponding to the bit position 0 to the bit position 5 in the to-be-encoded bit sequence as frozen bits. Then, the communication apparatus determines, based on reliability of subchannels corresponding to other bit positions (namely, a bit position 6 to a bit position 15), bit positions corresponding to information bits and bit positions corresponding to other frozen bits, to obtain a to-be-encoded bit sequence u = [$u_0\ u_1\ u_2 \ldots u_{14}\ u_{15}$]. The communication apparatus performs channel encoding on the to-be-encoded bit sequence to obtain an encoded bit sequence c = [$c_0\ c_1\ c_2 \ldots c_{14}\ c_{15}$], performs rate matching to delete bits $c_0$ to $c_5$ to obtain a rate-matched bit sequence $k_1$ = [$c_6\ c_7\ c_8 \ldots c_{14}\ c_{15}$], and sends the bit sequence $k_1$ to a receiving end.

However, according to the foregoing conclusion, if the capacity distribution of the subchannels of the polar code B before decoding may be obtained after the capacity distribution of the subchannels of the polar code A before decoding is processed by performing one or more of cyclic shift, mirror reversal, or segmented cyclic shift, the capacity distribution of the subchannels corresponding to the decoded sequences obtained after decoding of A and B is consistent. Correspondingly, the capacity distribution of the corresponding subchannels in the to-be-encoded bit sequences that respectively correspond to A and B before encoding is consistent.

In this example, after obtaining the encoded bit sequence c from the to-be-encoded bit sequence u, the communication apparatus may delete, in the rate matching process, bits corresponding to a bit position set $X_2$ in the encoded bit sequence to obtain a bit sequence $k_2$, and send the bit sequence to the receiving end. The bit position set $X_2$ is a set of bit positions obtained after the bit position 0 to the bit position 5 that are in the bit position set $X_1$ and that need to be deleted in the foregoing puncturing manner are processed by performing one or more of cyclic shift, mirror reversal, or segmented cyclic shift in the encoded bit sequence. Based on the foregoing conclusion, capacity distribution of subchannels corresponding to the decoded bit sequence remains unchanged, and the receiving end receives the bit sequence $k_2$ over the channel, and determines the LLR sequence corresponding to the sequence $k_2$. The receiving end then performs de-rate matching on the LLR sequence, and supplements, based on the bit position set $X_2$, LLRs corresponding to punctured bit positions to the LLR sequence, to obtain the LLR sequence whose length is N. For the rate matching in the puncturing manner, the LLRs supplemented to the bit positions included in the bit position set $X_2$ are 0. In other words, a probability that bits in the bit positions are 0 is equal to a probability that bits in the bit position are 1. The receiving end decodes the LLR sequence whose length is N to obtain the decoded bit sequence. A probability that the decoded bit sequence is the to-be-encoded bit sequence u is the same as a probability that the decoded bit sequence obtained after the receiving end receives the bit sequence $k_1$ and performs de-rate matching and then decoding based on the bit sequence set $X_1$ is the to-be-encoded bit sequence u.

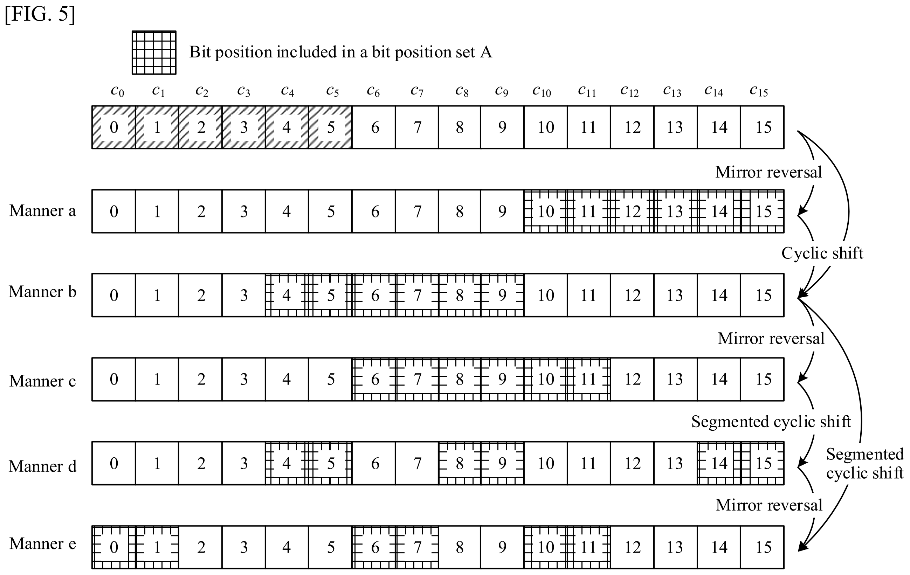

The bit position set $X_2$ may be a bit position set obtained in one of a manner a to a manner e shown in FIG. 5. For example, the manner a is a mirror reversal manner. A bit position 10 to a bit position 15 may be obtained when mirror reversal is performed on the bit position 0 to the bit position 5 in the encoded bit sequence. In other words, the bit position 0 to the bit position 5 included in the bit position set $X_1$ are mirror-symmetric to the bit position 10 to the bit position 15 included in the bit position set $X_2$ in the encoded bit sequence. Therefore, in the rate matching process, the communication apparatus may delete, instead of deleting bits corresponding to the bit position 0 to the bit position 5 in the encoded bit sequence, bits $c_{10}$ to $c_{15}$ corresponding to the bit position 10 to the bit position 15, and then send, to the receiving end, a sequence $[u_0 u_1 u_2 ... u_8 u_9]$ obtained through rate matching. The receiving end performs LLR padding on a corresponding LLR sequence based on the bit position 10 to the bit position 15, and then performs channel decoding to obtain the decoded bit sequence. Capacity distribution of subchannels corresponding to the decoded bit sequence remains unchanged after mirror reversal is performed based on bit positions corresponding to deleted bits. If the receiving end performs decoding correctly, the decoded bit sequence is the to-be-encoded bit sequence u, where in the to-be-encoded bit sequence, $u_0$ to $u_5$ are frozen bits known by the receiving end. Then, the receiving end obtains the information bit sequence from $u_6$ to $u_{15}$ based on reliability of subchannels corresponding to the bit position 6 to the bit position 15.

The manner b shown in FIG. 5 may be a manner of cyclic shift or a manner of cyclic shift after mirroring. The bit position set $X_2$ including the bit position 4 to the bit position 9 may be obtained based on the bit position 0 to the bit position 5. The manner c may be a manner of cyclic shift or mirror reversal after cyclic shift. The bit position set $X_2$ including the bit position 6 to the bit position 11 may be obtained based on the bit position 0 to the bit position 5. The manner d may be a manner of segmented cyclic shift after cyclic shift. Specifically, the bit position 6 to the bit position 11 are obtained when cyclic shift is performed on the bit position 0 to the bit position 5. Then, 16 bit positions are equally divided into two sections, and leftward cyclic shift of two bits is performed on each section, to obtain the bit position set $X_2$ including bit positions 4, 5, 8, 9, 14, and 15. The manner e may be a manner of segmented cyclic shift after cyclic shift, or a manner of mirror reversal after segmented cyclic shift after cyclic shift. For example, in the manner e, rightward segmented cyclic shift of two bits may be performed on the basis of the cyclic shift in the manner b, or mirror reversal may be performed on the basis of the manner d, to obtain the bit position set $X_2$ including bit positions 0, 1, 6, 7, 10, and 11. The receiving end and the transmitting end reach a consensus on using one of the foregoing manners a to e, and may obtain the to-be-encoded bit sequence u through decoding based on the bit position set $X_2$ and obtain the information bit sequence.

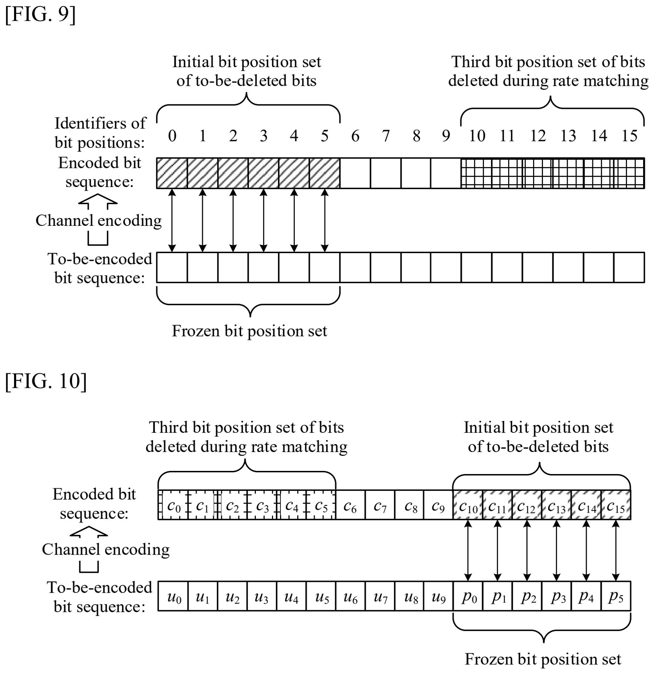

With reference to FIG. 4 and FIG. 5, rate matching in the puncturing manner is used as an example for description. The shortening manner is similar, and same effect can be achieved. A difference lies in that a check bit sequence corresponding to a frozen bit position set corresponding to positions of to-be-deleted initial bits needs to be calculated. Specifically, the check bit sequence corresponding to the frozen bit position set may be determined based on bits at bit positions other than the frozen bit position set in the to-be-encoded bit sequence, positions corresponding to bits that actually need to be deleted in the to-be-rate-matched bit sequence, and values of the bits that actually need to be deleted. For details, refer to the following description of the example shown in FIG. 10. However, this application is not limited thereto.

According to the foregoing solution, the binding relationship between the frozen bit position in the to-be-encoded bit sequence and the position of the bit deleted during rate matching can be removed, thereby improving flexibility of rate matching. For the communication apparatus that can implement both rate matching in the puncturing manner and rate matching in the shortening manner, the positions (for example, the first N-E bits or the last N-E bits) corresponding to the deleted bits can be unified, thereby reducing complexity of rate matching and de-rate matching, and reducing overheads of hardware implementation.

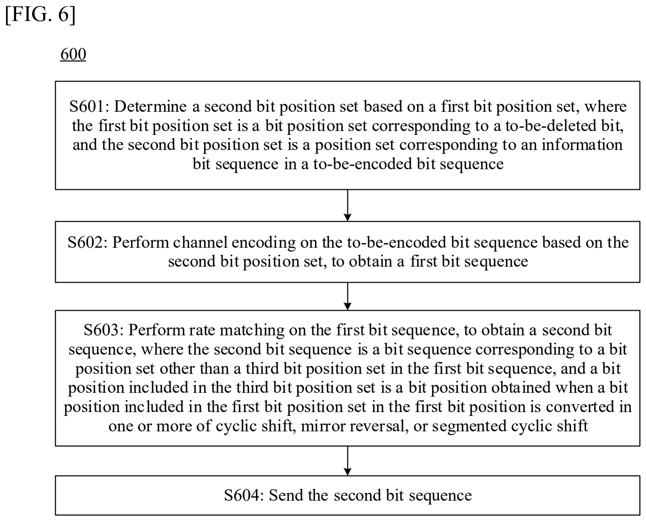

FIG. 6 is a schematic flowchart of a rate matching method 600 according to an embodiment of this application.

The following uses an example in which a first communication apparatus performs the method 600 for description. The first communication apparatus may be a communication device, or the first communication apparatus may be configured in a communication device. For example, the first communication apparatus may be a chip, a chip system, or the like. The method 600 includes but is not limited to the following steps.

S601: A first communication apparatus determines a second bit position set based on a first bit position set, where the first bit position set is an initial bit position set corresponding to a bit to be deleted, and the second bit position set is a position set corresponding to an information bit sequence in a to-be-encoded bit sequence.

For example, the first communication apparatus needs to send a first code block, and the first communication apparatus determines the information bit sequence based on the first code block. The information bit sequence includes a bit in the first code block. Optionally, the information bit sequence may further include a CRC bit of the first code block.

The first communication apparatus may determine, based on a size of a communication resource used to transmit the first code block, a quantity E of bits that can be actually sent, and may determine a first code rate $K_1/E$ based on a length $K_1$ of the information bit sequence, to determine a code length N for channel encoding based on the first code rate $K_1/E$. Then, the first communication apparatus performs S601 to determine a bit position (namely, a second bit position set) corresponding to an information bit and a bit position corresponding to a frozen bit in N bit positions of the to-be-encoded bit sequence.

Embodiments of this application mainly relate to a case in which E is less than N. Due to limitation of the size of the communication resource, the quantity E of bits that can be actually sent by the first communication apparatus is less than the code length N for channel encoding, the first communication apparatus needs to subsequently perform rate matching on an encoded bit sequence whose code length is N and that is obtained through channel encoding, and delete N-E bits from the encoded bit sequence, to obtain a bit sequence whose length is E. Initial bit positions (namely, bit positions in the first bit position set) corresponding to the to-be-deleted N-E bits may be predefined. For example, the bit positions in the first bit position set may be first N-E bit positions, last N-E bit positions, or N-E bit positions defined in a preset rule in the N bit positions.

The first communication apparatus may determine, based on the first bit position set, a frozen bit position set that is in the to-be-encoded bit sequence and that corresponds to the first bit position set. A bit position in the frozen bit position set is a bit position corresponding to a frozen bit in the to-be-encoded bit sequence. Then, a position set corresponding to the information bit sequence, namely, the second bit position set, is determined based on reliability of subchannels corresponding to bit positions other than the frozen bit position set in the to-be-encoded bit sequence. The first bit position set may be considered as a set of positions corresponding to bits that are assumed to be deleted during rate matching, and is not a set of positions corresponding to bits that are actually to be deleted during rate matching.

Whether the first communication apparatus performs interleaving processing on an encoded bit sequence obtained through channel encoding before rate matching may be classified into the following two implementations. The following separately describes, for the following Implementation 1 and Implementation 2, manners in which the first communication apparatus determines the second bit position set based on the first bit position set.

Implementation 1: In a physical layer processing procedure, before rate matching, the first communication apparatus does not perform interleaving (for example, bit interleaving or block interleaving) processing on the encoded bit sequence obtained through channel encoding, and the encoded bit sequence is used as a to-be-rate-matched bit sequence.

In Implementation 1, before channel encoding, to determine an information bit position and a frozen bit position in the to-be-encoded bit sequence, the first communication apparatus may pre-determine, based on an initial position set (namely, the first bit position set) corresponding to a to-be-deleted bit in the encoded bit sequence, a frozen bit position set that is in the to-be-encoded bit sequence and that corresponds to the first bit position set. Then, the first communication apparatus determines, from bit positions other than the frozen bit position set in the to-be-encoded bit sequence, the second bit position set corresponding to the information bit sequence.

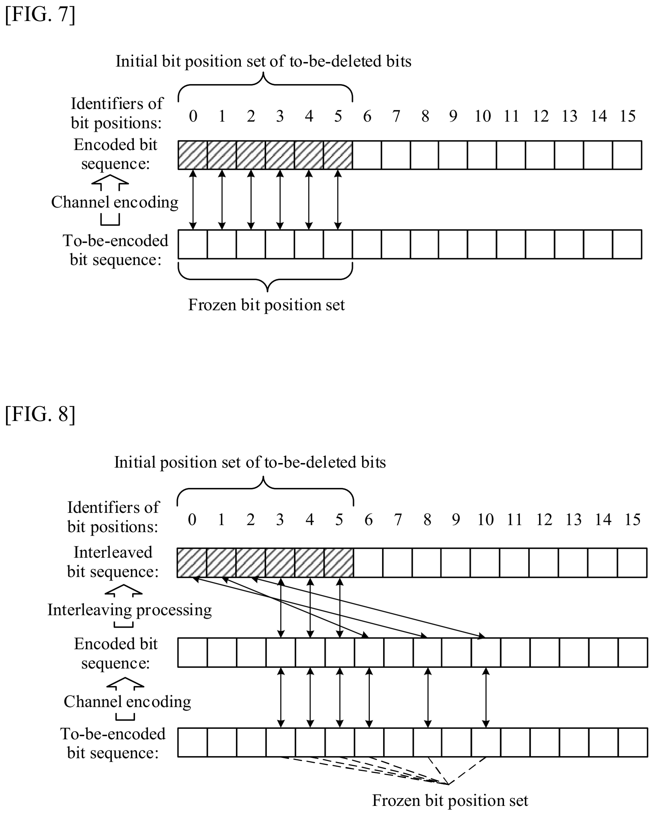

For example, polar code whose code length is 16 shown in FIG. 7 is used as an example. Before rate matching is performed in a subsequent processing process, the first communication apparatus does not perform interleaving processing on the encoded bit sequence obtained through channel encoding. An initial bit position set corresponding to bits to be deleted during rate matching includes six bit positions, namely, a bit position 10 to a bit position 15, in the encoded bit sequence. Correspondingly, the first communication apparatus may determine that a bit position 10 to a bit position 15 in the to-be-encoded bit sequence are bit positions corresponding to frozen bits. In other words, bit positions included in the frozen bit position set in the to-be-encoded bit sequence are the same as the bit positions included in the first bit position set, that is, both the frozen bit position set and the first bit position set include the bit positions whose identifiers are from 10 to 15.

After the first communication apparatus determines the frozen bit position set that is in the to-be-encoded bit sequence and that corresponds to the first bit position set, the first communication apparatus determines, based on reliability of subchannels corresponding to bit positions 0 to 9 other than the frozen bit position set in the to-be-encoded bit sequence, the second bit position set corresponding to the information bit sequence and positions of other frozen bits. The first communication apparatus may use a bit position with high reliability in the 10 bit positions as a position corresponding to the information bit sequence.

In another implementation, in the physical layer processing procedure, before rate matching, the first communication apparatus performs interleaving (for example, bit interleaving or block interleaving) processing on the encoded bit sequence obtained through channel encoding, and an interleaved bit sequence is used as the to-be-rate-matched bit sequence.

In Implementation 2, before channel encoding, to determine the information bit position and the frozen bit position in the to-be-encoded bit sequence, and when obtaining the interleaved bit sequence, the first communication apparatus may pre-determine a set (for example, denoted as a bit position set Y) of bit positions that are in the encoded bit sequence and to which bits that are before the interleaving and that correspond to bit positions in the first bit position set in the interleaved bit sequence correspond. Therefore, it is determined that the bit positions included in the bit position set Y in the to-be-encoded bit sequence are bit positions corresponding to the frozen bits, that is, the frozen bit position set that is in the to-be-encoded bit sequence and that corresponds to the first bit position set is the bit position set Y. Then, the first communication apparatus determines, from bit positions other than the frozen bit position set in the to-be-encoded bit sequence, the second bit position set corresponding to the information bit sequence.

For example, the encoded bit sequence is $[c_0 c_1 ... c_N]$, and the interleaved bit sequence is $[d_0 d_1 ... d_N]$, $d_i = c_{P(i)}$, where i=0,1, ..., N.

Herein, P(i) is an interleaver pattern (interleaver pattern) function. The first communication apparatus may determine, based on a bit position $i_{Delet}$ in the first bit position set, a bit position $P_{(iDelet)}$ that is in the encoded bit sequence and to which a bit that is before the interleaving and that corresponds to the bit position $i_{Delet}$ in the interleaved bit sequence corresponds. In this case, the bit position $P_{(iDelet)}$ is a frozen bit position in the to-be-encoded bit sequence, that is, a $(P_{(iDelet)}+1)^{th}$ bit position $u_{P(iDelet)}$ in the to-be-encoded bit sequence $[u_0 u_1 ... u_N]$ is a frozen bit position. After determining the frozen bit position set that is in the to-be-encoded bit sequence and that corresponds to the first bit position set, the first communication apparatus determines, based on reliability of subchannels corresponding to the bit positions, in the bit positions other than the frozen bit position set in the to-be-encoded bit sequence, the second bit position set corresponding to the information bit sequence.

For example, as shown in FIG. 8, an example in which the first communication apparatus needs to perform bit interleaving on the encoded bit sequence obtained through channel encoding before performing rate matching is used for description. For example, the initial position set of bits to be deleted during rate matching includes a bit position 10 to a bit position 15. Before channel encoding, to determine the information bit position and the frozen bit position in the to-be-encoded bit sequence, the first communication apparatus may pre-determine bit positions that are in the encoded bit sequence and to which bits that are before the interleaving and that correspond to bit positions in the first bit position set correspond. As shown in FIG. 8, a bit that is before the interleaving and that corresponds to the bit position 10 in the first bit position set corresponds to a bit position 8 in the encoded bit sequence (that is, $i_{Delet}$=10, and $P_{(iDelet)}$=8); a bit that is before the interleaving and that corresponds to the bit position 11 in the first bit position set corresponds to a bit position 5 in the encoded bit sequence (that is, $i_{Delet}$=11, and $P_{(iDelet)}$=5); a bit that is before the interleaving and that corresponds to the bit position 12 in the first bit position set corresponds to a bit position 10 in the encoded bit sequence (that is, $i_{Delet}$=12, and $P_{(iDelet)}$=10); and bits corresponding to the bit position 13 to the bit position 15 in the first bit position set respectively sequentially correspond to a bit position 13 to a bit position 15 in the encoded bit sequence. The first communication apparatus determines the bit position set Y that is in the encoded bit sequence and that corresponds to the first bit position set, and the bit position set Y includes the bit position 8, the bit position 5, the bit position 10, and the bit position 13 to the bit position 15. In this case, the first communication apparatus may determine the frozen bit position set that is in the to-be-encoded bit sequence and that corresponds to the first bit position set. Bit positions included in the frozen bit position set and the bit position set Y are the same. In other words, both the frozen bit position set and the bit position set Y include bit positions whose identifiers are 8, 5, 10, and 13 to 15. In other words, the frozen bit position set that is in the to-be-encoded bit sequence and that corresponds to the first bit position set is the bit position set Y.

S602: The first communication apparatus performs channel encoding on the to-be-encoded bit sequence based on the second bit position set, to obtain a first bit sequence.

Specifically, the first communication apparatus may determine the to-be-encoded bit sequence based on the second bit position set. The second bit position set in the to-be-encoded bit sequence corresponds to an information bit sequence, the second bit position set includes $K_1$ bit positions, and $K_1$ bits of the information bit sequence are respectively located in the $K_1$ bit positions included in the second bit position set in the to-be-encoded bit sequence. In addition, a bit position other than the $K_1$ bit positions in the to-be-encoded bit sequence corresponds to a frozen bit. After determining the to-be-encoded bit sequence, the first communication apparatus performs channel encoding on the to-be-encoded bit sequence to obtain the first bit sequence.

If the first communication apparatus uses the foregoing Implementation 1, the first bit sequence is the encoded bit sequence obtained by performing channel encoding on the to-be-encoded bit sequence by the first communication apparatus.

If the first communication apparatus uses the foregoing Implementation 2, the first bit sequence is a bit sequence obtained by the first communication apparatus by performing channel encoding on the to-be-encoded bit sequence to obtain the encoded bit sequence and then performing interleaving (for example, block interleaving or bit interleaving) processing on the encoded bit sequence.

S603: The first communication apparatus performs rate matching on the first bit sequence, to obtain a second bit sequence, where the second bit sequence is a bit sequence corresponding to a bit position set other than a third bit position set in the first bit sequence, and a bit position included in the third bit position set is a bit position obtained when a bit position included in the first bit position set in the first bit position is converted in one or more of cyclic shift, mirror reversal, or segmented cyclic shift.

As described above, the bit position corresponding to the bit deleted by the communication apparatus in the rate matching process is a bit position obtained when the bit position included in the initial bit position set is converted in one or more of cyclic shift, mirror reversal, or segmented cyclic shift. In this case, capacity distribution of subchannels corresponding to the to-be-encoded bit sequence remains unchanged. Therefore, the first communication apparatus deletes, in the rate matching process, bits corresponding to bit positions included in the third bit position set, and the capacity distribution of the subchannels corresponding to the to-be-encoded bit sequence remains unchanged, so that a decoding end can successfully obtain the to-be-encoded bit sequence through decoding.

For example, in the example shown in FIG. 7, the first communication apparatus determines, based on the bit position 0 to the bit position 5 in the initial bit position set (namely, the first bit position set) of bits to be deleted during rate matching, the frozen bit position set in the corresponding to-be-encoded bit sequence and the second bit position set corresponding to the information bit sequence, to determine the to-be-encoded bit sequence and then perform channel encoding to obtain the encoded bit sequence. The first communication apparatus performs rate matching on the encoded bit sequence (that is, the first bit sequence in this example is the encoded bit sequence), to obtain the second bit sequence corresponding to a bit position 0 to a bit position 9 in the encoded bit sequence. As shown in FIG. 9, the third bit position set corresponding to bits that are in the encoded bit sequence and that are deleted during rate matching includes a bit position 10 to a bit position 15. In other words, a bit position corresponding to an actually deleted bit may not be a bit position included in the first bit position set. The bit position 10 to the bit position 15 included in the third bit position set are bit positions obtained when the bit position 0 to the bit position 5 included in the first bit position set are converted through mirror reversal or cyclic shift in the encoded bit sequence. However, this application is not limited thereto. For example, the third bit position set may alternatively be a bit position set obtained in the manner shown in FIG. 5 or in another manner. It should be noted that

For another example, in the example shown in FIG. 8, after determining the to-be-encoded bit sequence based on the first bit position set, the first communication apparatus performs channel encoding on the to-be-encoded bit sequence to obtain the encoded bit sequence, and then performs interleaving to obtain the first bit sequence. The first communication apparatus performs rate matching on the first bit sequence to obtain the second bit sequence. Bits corresponding to bit positions in the third bit position set in the first bit sequence are deleted during rate matching. For example, the third bit position set may be a bit position set obtained by performing cyclic shift and segmented cyclic shift on the bit positions in the first bit position set in the first bit sequence in the example shown in FIG. 5 in the manner e, and includes bit positions 0, 1, 6, 7, 10, and 11. In other words, the second bit sequence includes bits corresponding to the bit positions 2 to 5, 7, and 8 and the bit positions 12 to 15 in the first bit sequence.

The first communication apparatus may perform rate matching on the first bit sequence in a puncturing manner or a shortening manner. When a length N of a bit sequence obtained through channel encoding is fixed and a length E of a bit sequence obtained through rate matching is fixed, the shortening manner and the puncturing manner for the rate matching performed by the first communication apparatus correspond to a same position of deleted bits. For example, bit position sets of bits deleted during rate matching in the shortening manner and the puncturing manner are the third bit position set.

According to the foregoing solution, a binding relationship between the frozen bit position in the to-be-encoded bit sequence and the position of the bit deleted during rate matching can be removed, thereby improving flexibility of rate matching. For the communication apparatus that can implement both rate matching in the puncturing manner and rate matching in the shortening manner, positions (for example, first N-E bits or last N-E bits) of bits deleted during rate matching can be unified, thereby reducing complexity of rate matching and de-rate matching, and reducing overheads of hardware implementation.

If rate matching performed by the first communication apparatus on the first bit sequence is in the puncturing manner, a capacity of a bit position that is in the to-be-encoded bit sequence and that corresponds to each bit position included in the first bit position set is assumed to be 0. To be specific, a capacity of each bit position in the frozen bit position set that is in the to-be-encoded bit sequence and that corresponds to the first bit position set is assumed to be 0, and a probability that a bit corresponding to a bit position in the frozen bit position set is correctly transmitted through a channel is low.

When a rate matching manner is the puncturing manner, the first communication apparatus determines, in S601, that the second bit position set in the to-be-encoded bit sequence is a set of bit positions corresponding to the information bit sequence, and that another bit position is a frozen bit position. In this case, a predefined bit sequence corresponding to a plurality of frozen bit positions in the to-be-encoded bit sequence is an all-0 sequence or an all-1 sequence. To be specific, each frozen bit position corresponds to 0 or 1. However, this application is not limited thereto. The predefined bit sequence may alternatively be a bit sequence that is agreed on by the first communication apparatus and the decoding end (for example, the decoding end is a second communication apparatus). A sequence that corresponds to the third bit position set in the first bit sequence and that is deleted by the first communication apparatus through rate matching is unknown to the second communication apparatus, and an LLR supplemented by the second communication apparatus to a bit position in the third bit position set during de-rate matching is 0, that is, a probability that a bit corresponding to the bit position is 0 is equal to a probability that a bit corresponding to the bit position is 1.

If the first communication apparatus performs rate matching on the first bit sequence in the shortening manner, a capacity of each bit position in the first bit position set is assumed to be a maximum capacity. To be specific, a capacity of each bit position in the frozen bit position set that is in the to-be-encoded bit sequence and that corresponds to the first bit position set is assumed to be the maximum capacity, and a probability that a bit corresponding to a bit position in the frozen bit position set is correctly transmitted through a channel is high.

When the rate matching manner is the shortening manner, before channel encoding, the first communication apparatus needs to determine, based on the third bit position set, a check bit sequence that is in the to-be-encoded bit sequence and that corresponds to the first bit position set. A sixth bit sequence that corresponds to the third bit position set and that is deleted by the first communication apparatus from the first bit sequence through rate matching is a predefined sequence known by the first communication apparatus and the second communication apparatus. The second communication apparatus performs channel decoding by using the sixth bit sequence as a known sequence. Therefore, the first communication apparatus needs to determine, based on the information bit sequence and the sixth bit sequence, the check bit sequence that is in the to-be-encoded bit sequence and that corresponds to the first bit position set, so that after the first communication apparatus performs channel encoding on the to-be-encoded bit sequence in S602, an obtained bit sequence that is in the first bit sequence and that corresponds to the third bit position set is the sixth bit sequence.

For example, FIG. 10 is an example in which the first communication apparatus uses Implementation 1. The first communication apparatus determines to perform rate matching on the first bit sequence in the shortening manner, and determines that the initial bit position set of the to-be-deleted bits includes the bit position 10 to the bit position 15, so that the first communication apparatus may determine that the frozen bit position set that is in the to-be-encoded bit sequence and that corresponds to the first bit position set includes the bit position 10 to the bit position 15. The first communication apparatus needs to determine, based on the sixth bit sequence corresponding to the bit position 0 to the bit position 5 actually to be deleted during rate matching, namely, $[c_0\ c_1\ c_2\ c_3\ c_4\ c_5]$ and the information bit sequence that is in the to-be-encoded bit sequence and that corresponds to the second bit position set, the check bit sequence $[p_0\ p_1\ p_2\ p_3\ p_4\ p_5] = [u_{10}\ u_{11}\ u_{12}\ u_{13}\ u_{14}\ u_{15}]$ corresponding to the frozen bit position set corresponding to the first bit position set. For example, the sixth bit sequence may be an all-0 sequence, namely, $[c_0\ c_1\ c_2\ c_3\ c_4\ c_5] = 000000$, or the sixth bit sequence may be an all-1 sequence, namely, $[c_0\ c_1\ c_2\ c_3\ c_4\ c_5] = 111111$, or the sixth bit sequence may be another sequence including 0 and 1.

In an implementation, the first communication apparatus may determine the check bit sequence based on a channel encoding generator polynomial, the information bit sequence, and the sixth bit sequence.

For example, the sixth bit sequence is an all-0 sequence. In the encoded bit sequence $c_0 = u_0 \oplus u_1 \oplus u_2 \cdots \oplus u_{14} \oplus u_{15}$, if $p_5 = u_{15} = u_0 \oplus u_1 \oplus u_2 \cdots \oplus u_{14}$, a generation formula $c_0 = u_{15} \oplus u_{15} = 0$ of $c_0$ may be obtained, so that $c_0$ is always 0 after channel encoding. Similarly, a generation formula that makes $c_1$, $c_2$, $c_3$, $c_4$, and $c_5$ always be 0 may be obtained through inference. When rate matching in the shortening manner is used, the first communication apparatus may obtain the check bit sequence through calculation based on the generation formula, the information bit sequence, and a predefined bit (for example, 0 or 1) of a frozen bit other than the frozen bit corresponding to the check bit sequence, to obtain the to-be-encoded bit sequence, so that the sequence that corresponds to the third bit position set and that is in the encoded bit sequence obtained through channel encoding is the sixth bit sequence.

In another implementation, the first communication apparatus decodes a first soft information sequence based on the information bit sequence, to obtain a seventh bit sequence, where a bit sequence that is in the seventh bit sequence and that corresponds to the first bit position set is the check bit sequence. The first soft information sequence and the first bit sequence have a same sequence length, a soft information sequence that is in the first soft information sequence and that corresponds to the third bit position set is a soft information sequence of the sixth bit sequence, soft information corresponding to a bit position other than the third bit position set is 0, and the information bit sequence is a sequence that is in the seventh bit sequence and that corresponds to the second bit position set.

In other words, the first communication apparatus performs a pseudo decoding process based on the information bit sequence, the sixth bit sequence, and the third bit position set, to obtain the check bit sequence that is in the to-be-encoded bit sequence and that corresponds to the first bit position set. Specifically, the first communication apparatus determines the first soft information sequence. The first soft information sequence includes N pieces of soft information. The first soft information sequence is a soft information sequence that is of the first bit sequence and that is assumed by the first communication apparatus before channel encoding to determine the check bit sequence. One piece of soft information in the first soft information sequence corresponds to one bit in the first bit sequence. Before channel encoding, the first communication apparatus can only determine that the sequence that is in the first bit sequence and that corresponds to the third bit position set is the sixth bit sequence, in this case, a soft information sequence that is in the first soft information sequence and that corresponds to the third bit position set is a soft information sequence of the sixth bit sequence, and soft information that corresponds to a bit position other than the third bit position set and that is in the first soft information sequence is 0, that is, a probability that a corresponding bit is 0 is equal to a probability that a corresponding bit is 1. In addition, the first communication apparatus may determine a known bit in the seventh bit sequence obtained by performing channel decoding on the first soft information sequence, that is, a sequence that is in the seventh bit sequence and that corresponds to the second bit position set is the information bit sequence, and a bit position other than the second bit position set and the frozen bit position set corresponding to the first bit position set corresponds to a frozen bit. In the seventh bit sequence, only the check bit sequence corresponding to the first bit position set needs to be obtained through channel decoding.

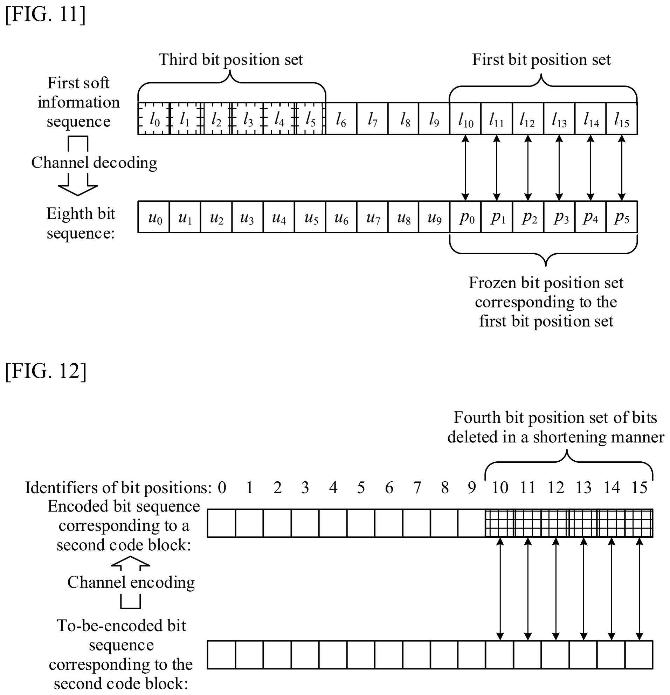

For example, the first communication apparatus needs to determine the check bit sequence in the to-be-encoded bit sequence shown in FIG. 10. The first communication apparatus determines, based on a code length N=16, the first soft information sequence including 16 pieces of soft information. As shown in FIG. 11, the first soft information sequence is $[l_0 l_1 l_2 l_3 ... l_{14} l_{15}]$. A soft information sequence $[l_0 l_1 l_2 l_3 l_4 l_5]$ that is in the first soft information sequence and that corresponds to the third bit position set is the soft information corresponding to the sixth bit sequence. For example, the sixth bit sequence is an all-0 sequence, and the soft information is an LLR of a probability $P_0$ of the bit being 0 to a probability $P_1$ of the bit being 1, that is, $\mathrm{LLR} = ln\left(\frac{P_0}{P_1}\right)$.

In this case, the soft information sequence of the sixth bit sequence is a quantized maximum value of the LLR, and $l_0$ to $l_5$ in the first soft information sequence are all quantized maximum values of the LLR. Optionally, because the LLR used by the first communication apparatus in the process of determining the check bit may only be positive infinity or negative infinity, a value 0 or 1, or positive 1 or negative 1 may be used to represent the maximum value of the LLR. This reduces processing overheads of the first communication apparatus. However, bits corresponding to bit positions other than $l_0$ to $l_5$ in the first soft information sequence are unknown, and are not used for decoding in an actual processing process. Therefore, a preset value of the LLR may be filled in these bit positions. For example, if the preset value is 0, $l_6$ to $l_{15}$ are all 0. In addition, the first communication apparatus may determine that a sequence in only a frozen bit position set that is in the seventh bit sequence and that corresponds to the first bit position set is the check bit sequence $[p_0 p_1 p_2 p_3 p_4 p_5]$ that needs to be obtained through channel decoding, the second bit position set in the bit position 0 to the bit position 9 corresponds the information bit sequence, and another bit position corresponds to the frozen bit. For example, it is predefined that the frozen bit is 0. The first communication apparatus performs channel decoding on the first soft information sequence based on the known bits $u_0$ to $u_9$ in the seventh bit sequence, to obtain the check bit sequence $[p_0 p_1 p_2 p_3 p_4 p_5]$, that is, obtain the seventh bit sequence. The seventh bit sequence is the to-be-encoded bit sequence on which channel encoding needs to be performed. In this way, the first communication apparatus may obtain, with low complexity by using the foregoing pseudo decoding process, the check bit sequence that is in the to-be-encoded bit sequence and that corresponds to the first bit position set.

In a physical layer processing process, if the first communication apparatus performs interleaving on the encoded bit sequence obtained through channel encoding and then performs rate matching, the first bit sequence is a sequence obtained after the encoded bit sequence obtained through channel encoding is interleaved, and the first soft information is the soft information sequence of the first bit sequence. That the first communication apparatus performs channel decoding on the first soft information specifically includes: The first communication apparatus performs channel decoding on the first soft information, to obtain the seventh bit sequence. Specifically, implementation may be performed with reference to the foregoing description. Details are not described herein again.

The sixth bit sequence may be predefined, or the first communication apparatus may send first information, where the first information indicates the sixth bit sequence. For example, a decoding end of a first code block is the second communication apparatus, and the second communication apparatus receives the first information to obtain the sixth bit sequence, so that the second communication apparatus performs channel decoding.

The foregoing describes a manner in which the first communication apparatus determines the check bit sequence in the to-be-encoded bit sequence if the first communication apparatus performs rate matching on the first bit sequence in the shortening manner.

In an optional implementation, the first communication apparatus may determine, based on a target code rate for rate matching, to use a rate matching manner, for example, the shortening manner or the puncturing manner.

Before the first communication apparatus determines the second bit position set based on the first bit position set, the first communication apparatus determines, based on a target code rate for rate matching corresponding to the first code block being a first code rate, to use a first rate matching manner. In addition, that the first communication apparatus performs rate matching on the first bit sequence is specifically that the first communication apparatus performs rate matching on the first bit sequence in the first rate matching manner, to obtain the second bit sequence.

For example, the first communication apparatus determines, based on a size of a communication resource used to transmit the first code block, the quantity E of bits that can be actually sent, and may determine the first code rate $K_1/E$ based on a length $K_1$ of the information bit sequence. Then, the first communication apparatus determines, based on a value relationship between the first code rate $K_1/E$ and a code rate threshold, to use the first rate matching manner. For example, the first code rate is less than or equal to the code rate threshold, and the first rate matching manner is the puncturing manner. Alternatively, the first code rate is greater than the code rate threshold, and the first rate matching manner is the shortening manner. The code rate threshold may be predefined.

S604: The first communication apparatus sends the second bit sequence.

For example, after the first communication apparatus obtains the second bit sequence through rate matching in S603, the first communication apparatus may perform digital modulation on the second bit sequence to obtain a plurality of modulated symbols, and send the plurality of modulated symbols including the second bit sequence.

For another example, if the first communication apparatus uses the OFDM technology, the first communication apparatus maps, to a frequency domain subcarrier of at least one OFDM symbol, the plurality of digital modulated symbols obtained when digital modulation is performed on the second bit sequence, and sends, after OFDM modulation, the OFDM symbol including the second bit sequence.

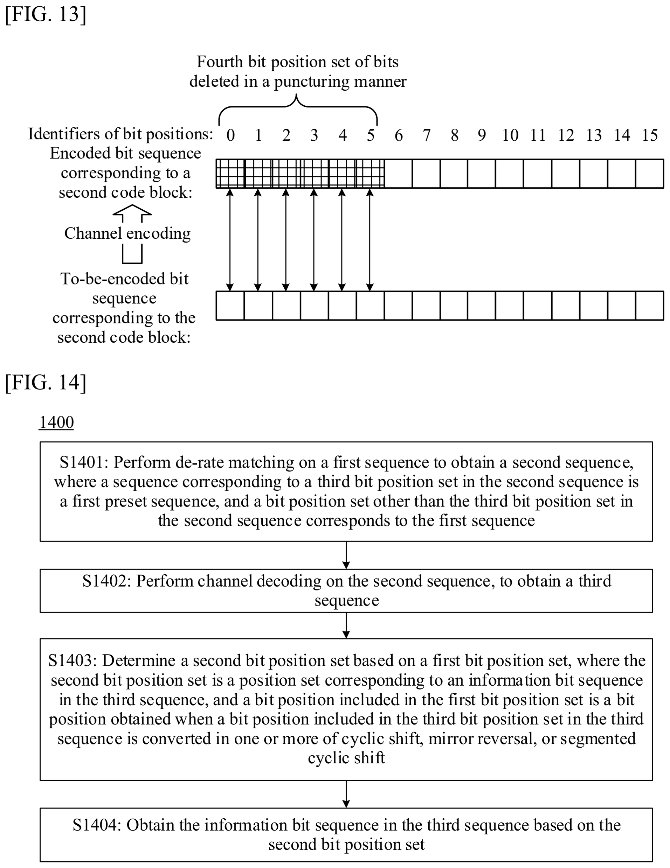

Correspondingly, the second communication apparatus may receive the second bit sequence from the first communication apparatus over the channel, and perform de-rate matching and channel decoding to obtain the information bit sequence. For details, refer to descriptions in the following embodiment shown in FIG. 14.

In an optional implementation, the first communication apparatus further needs to send a second code block, and the first communication apparatus determines, based on a target code rate for rate matching corresponding to the second code block being a second code rate, to use a second rate matching manner. The first communication apparatus determines a fifth bit position set based on a fourth bit position set. The fifth bit position set is a bit position set corresponding to an information bit sequence in a third bit sequence, and the fourth bit position set is a bit position set corresponding to a to-be-deleted bit. The first communication apparatus performs channel encoding on the third bit sequence based on the fifth bit position set, to obtain a fourth bit sequence; and performs rate matching on the fourth bit sequence in the second rate matching manner, to obtain a fifth bit sequence. The fifth bit sequence is a bit sequence corresponding to a position set other than the fourth bit position set in the fourth bit sequence. The first communication apparatus sends the fifth bit sequence.

The information bit sequence in the third bit sequence is an information bit sequence determined by the first communication apparatus based on the second code block, and the information bit sequence includes a bit in the second code block. Optionally, the information bit sequence may further include a CRC bit of the second code block.

If the first communication apparatus performs, in a physical layer processing process, interleaving on the encoded bit sequence obtained through channel encoding and then performs rate matching, that the first communication apparatus performs channel encoding on the third bit sequence based on the fifth bit position set, to obtain the fourth bit sequence specifically includes: The first communication apparatus performs channel encoding on the third bit sequence based on the fifth bit position set, to obtain the encoded bit sequence corresponding to the second code block, and performs interleaving on the encoded bit sequence corresponding to the second code block, to obtain the fourth bit sequence to perform rate matching.

For example, the first code rate is less than or equal to the code rate threshold, the first rate matching manner is the puncturing manner, the second code rate is greater than the code rate threshold, and the second rate matching manner is the shortening manner. Alternatively, the first code rate is greater than the code rate threshold, and the first rate matching manner is the shortening manner. The second code rate is less than or equal to the code rate threshold, and the second rate matching manner is the puncturing manner.

If the second code block and the first code block separately correspond to the same quantity E of bits that can be actually sent and separately correspond to the same code length N for channel encoding, a set of bit positions (namely, the third bit position set) of bits deleted from the sequence on which rate matching is to be performed (namely, the first bit sequence) by the first communication apparatus in a physical layer processing process of the first code block in the first rate matching manner and a set of bit positions (namely, the fourth bit position set) of bits deleted from the sequence on which rate matching is to be performed (namely, the fourth bit sequence) by the first communication apparatus in a physical layer processing process of the second code block in the second rate matching manner are the same. In other words, bit position identifiers included in the fourth bit position set are the same as those included in the third bit position set.

In an example, the first rate matching manner is the puncturing manner, and the second rate matching manner is the shortening manner. The first communication apparatus determines, based on a transmission resource corresponding to the second code block, that the quantity E of bits that can be actually sent is 10, determines, based on the second code rate $K_2/E$, that the code length N for channel encoding corresponding to the second code block is 16, and determines to use the shortening manner in the rate matching process. As shown in FIG. 12, the first communication apparatus determines that last N-E=6 bits need to be deleted in the rate matching process, that is, the fourth bit position set includes the bit position 10 to the bit position 15 in the encoded bit sequence (namely, the fourth bit sequence) corresponding to the second code block. The first communication apparatus determines, based on the fourth bit position set, that bit positions corresponding to the fourth bit position set in the to-be-encoded bit sequence (namely, the third bit sequence) corresponding to the second code block are frozen bit positions, that is, the fourth bit position set in the third bit sequence corresponds to the check bit sequence in the shortening manner. For example, the check bit sequence may be an all-0 sequence, so that the fourth bit position set in the encoded bit sequence obtained through channel encoding corresponds to a predefined sequence, for example, the all-0 sequence. The first communication apparatus determines, based on reliability of subchannels corresponding to the bit position 0 to the bit position 9 in the to-be-encoded bit sequence, the fifth bit position set corresponding to the information bit sequence, where another bit position corresponds to a frozen bit. After performing channel encoding on the third bit sequence, the first communication apparatus obtains the fourth bit sequence, and obtains, through rate matching, a fifth bit sequence corresponding to the bit position 0 to the bit position 9 in the fourth bit sequence, that is, a bit sequence corresponding to the fourth bit position set is deleted.

For example, if the quantity E of bits that can be actually sent and that correspond to the first code block is also 10, and the code length N for channel encoding is also 16, in the physical layer processing process of the first code block in the example in FIG. 9 and the physical layer processing process of the second code block in the example in FIG. 12, the first communication apparatus deletes bits corresponding to last six bit positions in the physical layer processing processes of the two code blocks, that is, bit position identifiers included in the third bit position set and the fourth bit position set are the same. The first communication apparatus can unify positions of bits deleted in different rate matching manners, thereby reducing complexity of rate matching and de-rate matching, and reducing overheads of hardware implementation.

In another example, the first rate matching manner is the shortening manner, and the second rate matching manner is the puncturing manner. The first communication apparatus determines, based on the transmission resource corresponding to the second code block, the quantity E of bits that can be actually sent is 10, determines, based on the second code rate $K_2/E$, the code length N for channel encoding corresponding to the second code block is 16, and determines to use the puncturing manner in the rate matching process. As shown in FIG. 13, the first communication apparatus determines that first N-E=6 bits need to be deleted in the rate matching process, that is, the fourth bit position set includes the bit position 0 to the bit position 5 in the encoded bit sequence (namely, the fourth bit sequence) corresponding to the second code block. The first communication apparatus determines, based on the fourth bit position set, that bit positions corresponding to the fourth bit position set in the to-be-encoded bit sequence (namely, the third bit sequence) corresponding to the second code block are frozen bit positions, that is, bit positions in the fourth bit position set in the third bit sequence correspond to frozen bits. The first communication apparatus determines, based on reliability of subchannels corresponding to the bit position 0 to the bit position 9 in the to-be-encoded bit sequence, the fifth bit position set corresponding to the information bit sequence, where another bit position corresponds to a frozen bit. After performing channel encoding on the third bit sequence, the first communication apparatus obtains the fourth bit sequence, and obtains, through rate matching, a fifth bit sequence corresponding to the bit position 6 to the bit position 15 in the fourth bit sequence, that is, a bit sequence corresponding to the fourth bit position set is deleted.

For example, if the quantity E of bits that can be actually sent and that correspond to the first code block is also 10, and the code length N for channel encoding is also 16, in the physical layer processing process of the first code block in the example in FIG. 10 and the physical layer processing process of the second code block in the example in FIG. 13, the first communication apparatus deletes bits corresponding to first six bit positions in the physical layer processing processes of the two code blocks, that is, the bit position identifiers included in the third bit position set and the fourth bit position set are the same. The first communication apparatus can unify the positions of the bits deleted in different rate matching manners, thereby reducing complexity of rate matching and de-rate matching, and reducing overheads of hardware implementation.

FIG. 14 is a schematic flowchart of a rate matching method 1400 according to an embodiment of this application. The following uses an example in which a second communication apparatus performs the method 1400 for description. The second communication apparatus may be a communication device, or the second communication apparatus may be configured in a communication device. For example, the second communication apparatus may be a chip, a chip system, or the like. The method 1400 includes but is not limited to the following steps.

S1401: A second communication apparatus performs de-rate matching on a first sequence to obtain a second sequence, where a sequence corresponding to a third bit position set in the second sequence is a first preset sequence, and a bit position set other than the third bit position set in the second sequence corresponds to the first sequence.

For example, the second communication apparatus receives a second bit sequence sent by the first communication apparatus by using the method 600 shown in FIG. 6, to obtain the first sequence. The first sequence is a soft information sequence determined by the second communication apparatus by using the second bit sequence.

The second communication apparatus may determine a length E of the second bit sequence based on a size of transmission resource of the second bit sequence, and the second communication apparatus may determine, based on an indication of the first communication apparatus, a length $K_1$ of an information bit sequence corresponding to a first code block. In this case, the second communication apparatus may determine that an encoding code rate of the first code block is a first code rate $K_1/E$, and the second communication apparatus determines a code length N for channel encoding and a quantity N-E of bits deleted during rate matching.

If the second communication apparatus and the first communication apparatus have consistent understanding on the third bit position set of the bit positions of the bits deleted during rate matching, the second communication apparatus performs de-rate matching on the first sequence to obtain the second sequence, where the sequence corresponding to the third bit position set in the second sequence is the first preset sequence, and the bit position set other than the third bit position set in the second sequence corresponds to the first sequence.

If the rate matching manner corresponding to the second bit sequence is the puncturing manner, all soft information LLRs included in the first preset sequence are 0. If the rate matching manner corresponding to the second bit sequence is the shortening manner, the first preset sequence is a soft information sequence of a sixth bit sequence. If the sixth bit sequence is an all-0 sequence, all soft information included in the first preset sequence is a quantized maximum value of an LLR. If the sixth bit sequence is an all-1 sequence, all soft information included in the first preset sequence is a quantized minimum value of the LLR. If the sixth bit sequence is a sequence including 0 and 1, a bit position corresponding to 0 in the first preset sequence is the quantized maximum value of the LLR, and a bit position corresponding to 1 is the quantized minimum value of the LLR.

The rate matching manner corresponding to the second bit sequence may be predefined or indicated by the first communication apparatus. For example, the second communication apparatus may determine, based on the first code rate, to use a de-rate matching manner, for example, a de-rate matching manner corresponding to the shortening manner or a de-rate matching manner corresponding to the puncturing manner. For example, the second communication apparatus determines, based on a value relationship between the first code rate $K_1/E$ and a code rate threshold, to use a first de-rate matching manner. For example, the first code rate is less than or equal to the code rate threshold, and the first de-rate matching manner is the de-rate matching manner corresponding to the puncturing manner; or the first code rate is greater than the code rate threshold, and the first de-rate matching manner is the de-rate matching manner corresponding to the shortening manner. The code rate threshold may be predefined.

S1402: The second communication apparatus performs channel decoding on the second sequence to obtain a third sequence.

If the first communication apparatus uses Implementation 1 in the embodiment shown in FIG. 6, and performs rate matching on the encoded bit sequence obtained through channel encoding without performing interleaving, the second communication apparatus does not perform de-interleaving on the second sequence, uses the second sequence as the to-be-decoded bit sequence for channel decoding, and obtains the third sequence through channel decoding.

If the first communication apparatus uses Implementation 2 in the embodiment shown in FIG. 6 to perform interleaving on the encoded bit sequence obtained through channel encoding and then perform rate matching, the second communication apparatus performs de-interleaving on the second sequence, uses a sequence obtained through de-interleaving of the second sequence as the to-be-decoded bit sequence for channel decoding, and obtains the third sequence through channel decoding.

S1403: The second communication apparatus determines a second bit position set based on a first bit position set, where the second bit position set is a position set corresponding to an information bit sequence in the third sequence, and a bit position included in the first bit position set is a bit position obtained when a bit position included in the third bit position set in the third sequence is converted in one or more of cyclic shift, mirror reversal, or segmented cyclic shift.

A manner in which the second communication apparatus determines the second bit position set based on the first bit position set is the same as that of the first communication apparatus. For a specific implementation, refer to the description of S601 in the embodiment shown in FIG. 6. For brevity, details are not described herein again.

S1404: The second communication apparatus obtains the information bit sequence in the third sequence based on the second bit position set.

After determining the second bit position set corresponding to the information bit sequence in the third sequence, the second communication apparatus may obtain the information bit sequence from the third sequence, so that the first code block is transmitted by the first communication apparatus to the second communication apparatus through a channel.

In an optional implementation, the second communication apparatus further needs to obtain the second code block from the first communication apparatus. The second communication apparatus receives the fifth bit sequence that is sent by the first communication apparatus and that includes the second code block, to obtain a fourth sequence. The second communication apparatus determines, based on a code rate of the fourth sequence being a second code rate, to use a second de-rate matching manner. The second communication apparatus performs de-rate matching on the fourth sequence in the second de-rate matching manner, to obtain a fifth sequence, where a sequence that is in the fifth sequence and that corresponds to a fourth bit position set is a second preset sequence, and a bit position set other than the fourth bit position set in the fifth sequence corresponds to the fourth sequence. The second communication apparatus performs channel decoding on the fifth sequence to obtain a sixth sequence. The second communication apparatus determines a fifth bit position set based on the fourth bit position set, where the fifth bit position set is a position set corresponding to an information bit sequence in the sixth sequence. The second communication apparatus obtains the information bit sequence in the sixth sequence based on the fifth bit position set.

For example, the first code rate is less than or equal to the code rate threshold, the first rate matching manner is the puncturing manner, the second code rate is greater than the code rate threshold, and the second rate matching manner is the shortening manner. Alternatively, the first code rate is greater than the code rate threshold, and the first rate matching manner is the shortening manner. The second code rate is less than or equal to the code rate threshold, and the second rate matching manner is the puncturing manner.

If the second code block and the first code block separately correspond to the same quantity E of bits that can be actually sent and separately correspond to the same code length N for channel encoding, a set of bit positions (namely, the third bit position set) of soft information filled in the first sequence by the second communication apparatus through de-rate matching in the first de-rate matching manner in a physical layer processing process of the first code block and a set of bit positions (namely, the fourth bit position set) that are of soft information filled in the fourth sequence by the second communication apparatus through de-rate matching in the second de-rate matching manner in a physical layer processing process of the second code block are the same. In other words, bit position identifiers included in the fourth bit position set are the same as those included in the third bit position set. In this way, the second communication apparatus can unify positions of soft information filled in different de-rate matching manners, thereby reducing complexity of rate matching and de-rate matching, and reducing overheads of hardware implementation.

It may be understood that to implement functions in the foregoing embodiments, the base station and the terminal include corresponding hardware structures and/or software modules for performing various functions. A person skilled in the art should be easily aware that, in combination with the units and the method steps in the examples described in embodiments disclosed in this application, this application can be implemented by using hardware or a combination of hardware and computer software. Whether a function is performed by hardware or hardware driven by computer software depends on particular application scenarios and design constraints of the technical solutions.

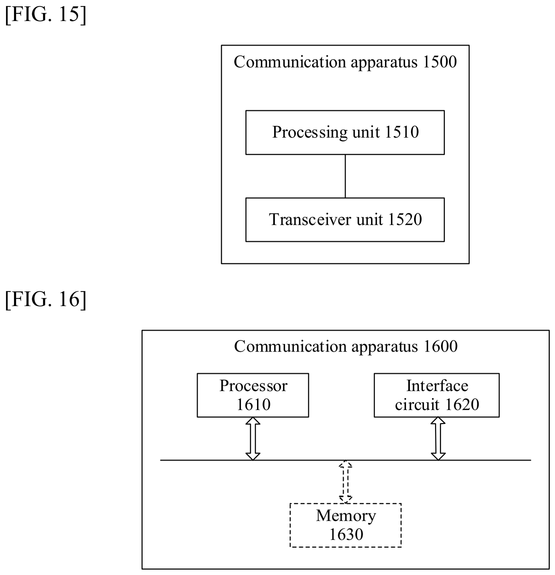

FIG. 15 and FIG. 16 are diagrams of structures of possible communication apparatuses according to embodiments of this application. The communication apparatuses may be configured to implement functions of the first communication apparatus or functions of the second communication apparatus in the foregoing method embodiments, and therefore can also implement beneficial effect of the foregoing method embodiments. In this embodiment of this application, the communication apparatus may be one of the terminal devices 120a to 120g shown in FIG. 1, or may be the network device 110a or 110b shown in FIG. 1, or may be a module (for example, a chip) used in a terminal device or a network device.

The communication apparatus 1500 includes a transceiver unit 1520, and the transceiver unit 1520 may be configured to receive or send information. The communication apparatus 1500 may further include a processing unit 1510, and the processing unit 1510 may be configured to process instructions or data, to implement corresponding operations.

It should be understood that when the communication apparatus 1500 is a chip disposed (or configured) in a communication device, the transceiver unit 1520 in the communication apparatus 1500 may be an input/output interface or circuit in the chip, and the processing unit 1510 in the communication apparatus 1500 may be a processor in the chip.

Optionally, the communication apparatus 1500 may further include a storage unit 1530. The storage unit 1530 may be configured to store instructions or data. The processing unit 1510 may execute the instructions or the data stored in the storage unit, to enable the communication apparatus to implement corresponding operations.

The communication apparatus 1500 may be configured to implement the first communication apparatus in the method embodiment shown in FIG. 6. When the communication apparatus 1500 is configured to implement a function of the first communication apparatus in the method embodiment shown in FIG. 6, the processing unit 1510 is configured to determine a second bit position set based on a first bit position set, where the first bit position set is an initial position set corresponding to a bit to be deleted during rate matching, and the second bit position set is a position set corresponding to an information bit sequence in a to-be-encoded bit sequence. The processing unit 1510 is further configured to: perform, based on the second bit position set, channel encoding on the to-be-encoded bit sequence to obtain a first bit sequence; and perform rate matching on the first bit sequence to obtain a second bit sequence, where the second bit sequence is a bit sequence corresponding to a bit position set other than a third bit position set in the first bit sequence, and a bit position included in the third bit position set is a bit position obtained when a bit position included in the first bit position set in the first bit sequence is converted in one or more of cyclic shift, mirror reversal, or segmented cyclic shift. The transceiver unit 1520 is configured to send the second bit sequence.

The communication apparatus 1500 may be configured to implement the second communication apparatus in the method embodiment shown in FIG. 14. When the communication apparatus 1500 may be configured to implement a function of the second communication apparatus in the method embodiment shown in FIG. 14, the transceiver unit 1520 is configured to receive a first sequence. The processing unit 1510 is configured to perform de-rate matching on the first sequence to obtain a second sequence, where a sequence corresponding to a third bit position set in the second sequence is a first preset sequence, and a bit position set other than the third bit position set in the second sequence corresponds to the first sequence. In addition, the processing unit 1510 is further configured to perform channel decoding on the second sequence to obtain a third sequence; and determine a second bit position set based on a first bit position set. The second bit position set is a position set corresponding to an information bit sequence in the third sequence, and a bit position included in the first bit position set is a bit position obtained when a bit position included in the third bit position set in the third sequence is converted in one or more of cyclic shift, mirror reversal, or segmented cyclic shift. The processing unit 1510 is further configured to obtain the information bit sequence in the third sequence based on the second bit position set.

For more detailed descriptions of the processing unit 1510 and the transceiver unit 1520, refer to related descriptions in the method embodiments shown in FIG. 6 and FIG. 14.

It should be understood that the transceiver unit 1520 in the communication apparatus 1500 can be implemented by using a communication interface (for example, a transceiver, a transceiver circuit, an input/output interface, or a pin). When the communication interface is a transceiver, the transceiver may include a receiver and/or a transmitter. The processing unit 1510 in the communication apparatus 1500 may be implemented by using at least one processor. The processing unit 1510 in the communication apparatus 1500 may alternatively be implemented by using at least one logic circuit. Optionally, the communication apparatus 1500 further includes a memory unit, and the memory unit may be implemented by using a memory.

As shown in FIG. 16, a communication apparatus 1600 includes a processor 1610 and an interface circuit 1620. The processor 1610 and the interface circuit 1620 are coupled to each other. It can be understood that the interface circuit 1620 may be a transceiver or an input/output interface. Optionally, the communication apparatus 1600 may further include a memory 1630, configured to: store instructions executed by the processor 1610, store input data required by the processor 1610 to run the instructions, or store data generated after the processor 1610 runs the instructions.

When the communication apparatus 1600 is configured to implement the method shown in FIG. 16, the processor 1610 is configured to implement the function of the processing unit 1510, and the interface circuit 1620 is configured to implement the function of the transceiver unit 1520.

When the communication apparatus is a chip used in a terminal device, the chip may implement the function of the first communication apparatus and/or the function of the second communication apparatus in the foregoing method embodiment. The chip receives information from another module (for example, a radio frequency module or an antenna) in the terminal device, where the information is sent by a network device to the terminal device; or the chip sends information to another module (for example, a radio frequency module or an antenna) in the terminal device, where the information is sent by the terminal device to a network device.

When the communication apparatus is a module used in the network device, the module may implement the function of the first communication apparatus and/or the function of the second communication apparatus in the foregoing method embodiment. The module receives information from another module (for example, a radio frequency module or an antenna) in the network device, where the information is sent by a terminal device to the network device; or the module sends information to another module (for example, a radio frequency module or an antenna) in the terminal device, where the information is sent by the network device to a terminal device.

It may be understood that the processor in this embodiment of this application may be a central processing unit (Central Processing Unit, CPU), or may be another general-purpose processor, a digital signal processor (Digital Signal Processor, DSP), an application-specific integrated circuit (Application-Specific Integrated Circuit, ASIC), a field programmable gate array (Field Programmable Gate Array, FPGA) or another programmable logic device, a transistor logic device, a hardware component, or any combination thereof. The general purpose processor may be a microprocessor, or may be any conventional processor.

The method steps in embodiments of this application may be implemented in hardware, or may be implemented in software instructions that may be executed by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a CD-ROM, or any other form of storage medium well-known in the art. For example, a storage medium is coupled to a processor, so that the processor can read information from the storage medium and write information into the storage medium. The storage medium may alternatively be a component of the processor. The processor and the storage medium may be disposed in an ASIC. In addition, the ASIC may be located in an access network device or a terminal device. The processor and the storage medium may alternatively exist as discrete components in the access network device or the terminal device.

According to the methods provided in embodiments of this application, an embodiment of this application further provides a computer program product. The computer program product includes computer program code. When the computer program code is executed by one or more processors, an apparatus including the processor is enabled to perform the method shown in FIG. 6.

All or some of the foregoing embodiments may be implemented by software, hardware, firmware, or any combination thereof. When software is used to implement the methods, all or some of embodiments may be implemented in a form of computer program product. The computer program product includes one or more computer programs or instructions. When the computer programs or instructions are loaded and executed on a computer, the procedures or functions in embodiments of this application are all or partially executed. The computer may be a general-purpose computer, a dedicated computer, a computer network, a network device, user equipment, or another programmable

# EP 4 661 322 A1

apparatus.

According to the methods provided in embodiments of this application, an embodiment of this application further provides a computer-readable storage medium, and the computer-readable storage medium stores a computer program or instructions. When the computer program or instructions are run by one or more processors, an apparatus including the processor is enabled to perform the method shown in FIG. 6.

The computer programs or the instructions may be stored in the computer-readable storage medium, or may be transmitted from a computer-readable storage medium to another computer-readable storage medium. For example, the computer programs or the instructions may be transmitted from a website, computer, server, or data center to another website, computer, server, or data center in a wired or wireless manner. The computer-readable storage medium may be any usable medium accessible by a computer, or a data storage device like a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

According to the methods provided in embodiments of this application, an embodiment of this application further provides a communication system that includes the foregoing one or more first communication apparatuses. The system may further include the foregoing one or more second communication apparatuses.

In several embodiments provided in this application, it should be understood that the disclosed system, apparatus, and method may be implemented in other manners. For example, the described apparatus is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A rate matching method, comprising:

   determining a second bit position set based on a first bit position set, wherein the first bit position set is an initial position set corresponding to a bit to be deleted during rate matching, and the second bit position set is a position set corresponding to an information bit sequence in a to-be-encoded bit sequence;
   performing channel encoding on the to-be-encoded bit sequence based on the second bit position set, to obtain a first bit sequence;
   performing rate matching on the first bit sequence to obtain a second bit sequence, wherein the second bit sequence is a bit sequence corresponding to a bit position set other than a third bit position set in the first bit sequence, and a bit position comprised in the third bit position set is a bit position obtained when a bit position comprised in the first bit position set in the first bit sequence is converted in one or more of cyclic shift, mirror reversal, or segmented cyclic shift; and
   sending the second bit sequence.

2. The method according to claim 1, wherein the rate matching is in a shortening manner or a puncturing manner, and when a length of a bit sequence obtained through channel encoding is fixed and a length of a bit sequence obtained through rate matching is fixed, the shortening manner and the puncturing manner for the rate matching correspond to a same position of deleted bits.

3. The method according to claim 1 or 2, wherein before determining the second bit position set based on the first bit

23

position set, the method further comprises:

> determining, based on a target code rate for the rate matching being a first code rate, to use a first rate matching manner; and
> performing rate matching on the first bit sequence to obtain the second bit sequence comprises:
> performing rate matching on the first bit sequence in the first rate matching manner, to obtain the second bit sequence.

4. The method according to claim 3, wherein the method further comprises:

> determining, based on the target code rate for the rate matching being a second code rate, to use a second rate matching manner;
> determining a fifth bit position set based on a fourth bit position set, wherein the fifth bit position set is a position set corresponding to an information bit sequence in a third bit sequence, and the fourth bit position set is a position set corresponding to a to-be-deleted bit;
> performing channel encoding on the third bit sequence based on the fifth bit position set, to obtain a fourth bit sequence;
> performing rate matching on the fourth bit sequence in the second rate matching manner, to obtain a fifth bit sequence, wherein the fifth bit sequence is a bit sequence corresponding to a position set other than the fourth bit position set in the fourth bit sequence; and
> sending the fifth bit sequence.

5. The method according to claim 4, wherein the first code rate is less than or equal to a code rate threshold, the first rate matching manner is the puncturing manner, the second code rate is greater than the code rate threshold, and the second rate matching manner is the shortening manner; or the first code rate is greater than a code rate threshold, the first rate matching manner is the shortening manner, the second code rate is less than or equal to the code rate threshold, and the second rate matching manner is the puncturing manner.

6. The method according to any one of claims 1 to 5, wherein the rate matching is in the puncturing manner, and a capacity of a bit position that is in the to-be-encoded bit sequence and that corresponds to each bit position comprised in the first bit position set is assumed to be 0.

7. The method according to any one of claims 1 to 5, wherein the rate matching is in the shortening manner, and a capacity that is in the to-be-encoded bit sequence and that corresponds to each bit position comprised in the first bit position set is assumed to be a maximum capacity.

8. The method according to any one of claims 1 to 5, and 7, wherein the rate matching is in the shortening manner, and the method further comprises:
determining, based on the information bit sequence and a sixth bit sequence, a check bit sequence that is in the to-be-encoded bit sequence and that corresponds to the first bit position set, wherein the sixth bit sequence is a predefined bit sequence corresponding to the third bit position set in the first bit sequence.

9. The method according to claim 8, wherein the method further comprises:
sending first information, wherein the first information indicates the sixth bit sequence, and the sixth bit sequence is used for channel decoding.

10. The method according to claim 8 or 9, wherein determining, based on the information bit sequence and the sixth bit sequence, the check bit sequence that is in the to-be-encoded bit sequence and that is in the first bit position set comprises:

> decoding a first soft information sequence based on the information bit sequence, to obtain a seventh bit sequence, wherein a bit sequence that is in the seventh bit sequence and that corresponds to the first bit position set is the check bit sequence; and
> the first soft information sequence and the first bit sequence have a same sequence length, a soft information sequence that is in the first soft information sequence and that corresponds to the third bit position set is a soft information sequence of the sixth bit sequence, soft information corresponding to a bit position other than the third bit position set is 0, and the information bit sequence is a seventh bit sequence of a sequence that is in the seventh bit sequence and that corresponds to the second bit position set.

11. A de-rate matching method, comprising:

performing de-rate matching on a first sequence to obtain a second sequence, wherein a sequence corresponding to a third bit position set in the second sequence is a first preset sequence, and a bit position set other than the third bit position set in the second sequence corresponds to the first sequence;

performing channel decoding on the second sequence to obtain a third sequence;

determining a second bit position set based on a first bit position set, wherein the second bit position set is a position set corresponding to an information bit sequence in the third sequence, and a bit position comprised in the first bit position set is a bit position obtained when a bit position comprised in the third bit position set in the third sequence is converted in one or more of cyclic shift, mirror reversal, or segmented cyclic shift; and

obtaining the information bit sequence in the third sequence based on the second bit position set.

12. The method according to claim 11, wherein the de-rate matching is de-rate matching corresponding to a shortening manner or a puncturing manner, and when a length of a sequence on which de-rate matching is to be performed is fixed, and a length of a sequence obtained through de-rate matching is fixed, preset sequences in sequences obtained through de-rate matching corresponding to the shortening manner and the puncturing manner correspond to a same bit position set.

13. The method according to claim 11 or 12, wherein before performing de-rate matching on the first sequence to obtain the second sequence, the method further comprises:

determining, based on a code rate of the first sequence being a first code rate, to use a first de-rate matching manner; and

performing de-rate matching on the first sequence to obtain the second sequence comprises:

performing de-rate matching on the first sequence in the first de-rate matching manner, to obtain the second sequence.

14. The method according to claim 13, wherein the method further comprises:

determining, based on a code rate of a fourth sequence being a second code rate, to use a second de-rate matching manner;

performing de-rate matching on the fourth sequence in the second de-rate matching manner, to obtain a fifth sequence, wherein a sequence that is in the fifth sequence and that corresponds to a fourth bit position set is a second preset sequence, and a bit position set other than the fourth bit position set in the fifth sequence corresponds to the fourth sequence;

performing channel decoding on the fifth sequence to obtain a sixth sequence;

determining a fifth bit position set based on the fourth bit position set, wherein the fifth bit position set is a position set corresponding to an information bit sequence in the sixth sequence; and

obtaining the information bit sequence in the sixth sequence based on the fifth bit position set.

15. The method according to claim 14, wherein

the first code rate is less than or equal to a code rate threshold, the first de-rate matching manner is a de-rate matching manner corresponding to the puncturing manner, the second code rate is greater than the code rate threshold, and the second de-rate matching manner is a de-rate matching manner corresponding to the shortening manner; or

the first code rate is greater than a code rate threshold, the first de-rate matching manner is a de-rate matching manner corresponding to the shortening manner, the second code rate is less than or equal to the code rate threshold, and the second de-rate matching manner is a de-rate matching manner corresponding to the puncturing manner.

16. The method according to any one of claims 11 to 15, wherein the method further comprises:

receiving first information, wherein the first information indicates a sixth bit sequence, and

the first preset sequence is a log-likelihood ratio LLR sequence corresponding to the sixth bit sequence.

17. A communication apparatus, comprising a processor, wherein the processor is configured to execute a computer program stored in a memory, to enable the communication apparatus to perform the method according to any one of claims 1 to 16.

**18.** The apparatus according to claim 17, wherein the processor comprises the memory.

**19.** A communication apparatus, comprising a logic circuit and a communication interface, wherein the logic circuit is configured to process to-be-processed information to obtain processed information, and the communication interface is configured to: obtain the to-be-processed information and/or output the processed information, to enable the communication apparatus to perform the method according to any one of claims 1 to 16.

**20.** A computer-readable storage medium, wherein the computer-readable storage medium stores a computer program, and when the computer program is run, the method according to any one of claims 1 to 16 is implemented.

**21.** A computer program product, wherein the computer program product comprises a computer program, and when the computer program is run, a computer is enabled to perform the method according to any one of claims 1 to 16.

**22.** A communication system, comprising a communication apparatus configured to perform the method according to any one of claims 1 to 10 and a communication apparatus configured to indicate the method according to any one of claims 11 to 16.

[FIG. 1]

[FIG. 2]

[FIG. 3]

$\oplus$ Exclusive OR operation    ⌐ ¬ Frozen bit

[FIG. 3a]

| Upper left unit | $\oplus$ | Upper right unit |
| Lower left unit | | Lower right unit |

[FIG. 4]

▨ Bit deleted during rate matching

Encoded bit sequence

Channel encoding

To-be-encoded bit sequence

Frozen bit positions

[FIG. 5]

[FIG. 6]

600

```
S601: Determine a second bit position set based on a first bit position set, where
the first bit position set is a bit position set corresponding to a to-be-deleted bit,
and the second bit position set is a position set corresponding to an information
bit sequence in a to-be-encoded bit sequence
```

```
S602: Perform channel encoding on the to-be-encoded bit sequence based on the
second bit position set, to obtain a first bit sequence
```

```
S603: Perform rate matching on the first bit sequence, to obtain a second bit
sequence, where the second bit sequence is a bit sequence corresponding to a bit
position set other than a third bit position set in the first bit sequence, and a bit
position included in the third bit position set is a bit position obtained when a bit
position included in the first bit position set in the first bit position is converted in
one or more of cyclic shift, mirror reversal, or segmented cyclic shift
```

```
S604: Send the second bit sequence
```

[FIG. 7]

[FIG. 8]

[FIG. 9]

Initial bit position set
of to-be-deleted bits

Third bit position set of bits
deleted during rate matching

Identifiers of
bit positions:

| 0 | 1 | 2 | 3 | 4 | 5 | 6 | 7 | 8 | 9 | 10 | 11 | 12 | 13 | 14 | 15 |

Encoded bit
sequence:

Channel encoding

To-be-encoded
bit sequence:

Frozen bit position set

[FIG. 10]

Third bit position set of bits
deleted during rate matching

Initial bit position set
of to-be-deleted bits

Encoded bit
sequence:

| $c_0$ | $c_1$ | $c_2$ | $c_3$ | $c_4$ | $c_5$ | $c_6$ | $c_7$ | $c_8$ | $c_9$ | $c_{10}$ | $c_{11}$ | $c_{12}$ | $c_{13}$ | $c_{14}$ | $c_{15}$ |

Channel encoding

To-be-encoded
bit sequence:

| $u_0$ | $u_1$ | $u_2$ | $u_3$ | $u_4$ | $u_5$ | $u_6$ | $u_7$ | $u_8$ | $u_9$ | $p_0$ | $p_1$ | $p_2$ | $p_3$ | $p_4$ | $p_5$ |

Frozen bit position set

[FIG. 11]

Third bit position set

First bit position set

First soft
information
sequence

| $l_0$ | $l_1$ | $l_2$ | $l_3$ | $l_4$ | $l_5$ | $l_6$ | $l_7$ | $l_8$ | $l_9$ | $l_{10}$ | $l_{11}$ | $l_{12}$ | $l_{13}$ | $l_{14}$ | $l_{15}$ |

Channel decoding

Eighth bit
sequence:

| $u_0$ | $u_1$ | $u_2$ | $u_3$ | $u_4$ | $u_5$ | $u_6$ | $u_7$ | $u_8$ | $u_9$ | $p_0$ | $p_1$ | $p_2$ | $p_3$ | $p_4$ | $p_5$ |

Frozen bit position set
corresponding to the
first bit position set

[FIG. 12]

Fourth bit position set of bits
deleted in a shortening manner

Identifiers of bit positions: 0 1 2 3 4 5 6 7 8 9 10 11 12 13 14 15

Encoded bit sequence
corresponding to a
second code block:

Channel encoding

To-be-encoded bit
sequence
corresponding to the
second code block:

[FIG. 13]

Fourth bit position set of bits
deleted in a puncturing manner

Identifiers of bit positions: 0 1 2 3 4 5 6 7 8 9 10 11 12 13 14 15

Encoded bit sequence
corresponding to a
second code block:

↑
Channel encoding
⊔

To-be-encoded bit
sequence
corresponding to the
second code block:

[FIG. 14]

1400

S1401: Perform de-rate matching on a first sequence to obtain a second sequence, where a sequence corresponding to a third bit position set in the second sequence is a first preset sequence, and a bit position set other than the third bit position set in the second sequence corresponds to the first sequence

S1402: Perform channel decoding on the second sequence, to obtain a third sequence

S1403: Determine a second bit position set based on a first bit position set, where the second bit position set is a position set corresponding to an information bit sequence in the third sequence, and a bit position included in the first bit position set is a bit position obtained when a bit position included in the third bit position set in the third sequence is converted in one or more of cyclic shift, mirror reversal, or segmented cyclic shift

S1404: Obtain the information bit sequence in the third sequence based on the second bit position set

[FIG. 15]

Communication apparatus 1500

Processing unit 1510

Transceiver unit 1520

[FIG. 16]

Communication apparatus 1600

Processor 1610

Interface circuit 1620

Memory 1630

## INTERNATIONAL SEARCH REPORT

| International application No. |
|---|
| **PCT/CN2023/076267** |

**A. CLASSIFICATION OF SUBJECT MATTER**

H04L 1/00(2006.01)i

According to International Patent Classification (IPC) or to both national classification and IPC

**B. FIELDS SEARCHED**

Minimum documentation searched (classification system followed by classification symbols)

IPC: H04L, H04W

Documentation searched other than minimum documentation to the extent that such documents are included in the fields searched

Electronic data base consulted during the international search (name of data base and, where practicable, search terms used)

3GPP, CNTXT, ENTXT, IEEE: 比特, 初始, 除, 打孔, 翻转, 极化, 镜像, 匹配, 容量, 删, 速率, 缩短, 位, 位置, 相同, 循环移位, 最大, 码率, 校验, 对数似然比, 软信息, RATE, CODE, CODING, POLAR, PUNCTURE, REVERSE, SHIFT, MATCH+, FROZEN BIT?, PUNCTUR+, DELET+, INITIAL+, REVERS+, SHORTEN+, LLR

**C. DOCUMENTS CONSIDERED TO BE RELEVANT**

| Category* | Citation of document, with indication, where appropriate, of the relevant passages | Relevant to claim No. |
|---|---|---|
| X | CN 109525360 A (HUAWEI TECHNOLOGIES CO., LTD.) 26 March 2019 (2019-03-26) description, paragraphs [0066]-[0202] | 1, 3-9, 11, 13-22 |
| A | CN 106603084 A (NO.20 RESEARCH INSTITUTE OF CETC) 26 April 2017 (2017-04-26) entire document | 1-22 |
| A | CN 107342846 A (HUAWEI TECHNOLOGIES CO., LTD.) 10 November 2017 (2017-11-10) entire document | 1-22 |
| A | CN 107359967 A (BEIHANG UNIVERSITY) 17 November 2017 (2017-11-17) entire document | 1-22 |
| A | CN 107425941 A (HUAWEI TECHNOLOGIES CO., LTD.) 01 December 2017 (2017-12-01) entire document | 1-22 |
| A | CN 110391874 A (HUAWEI TECHNOLOGIES CO., LTD.) 29 October 2019 (2019-10-29) entire document | 1-22 |
| A | CN 115173992 A (HUAWEI TECHNOLOGIES CO., LTD.) 11 October 2022 (2022-10-11) entire document | 1-22 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **31 October 2023** | **31 October 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| :--- |
| **PCT/CN2023/076267** |

| C. | DOCUMENTS CONSIDERED TO BE RELEVANT | |
| :---: | :--- | :---: |
| Category* | Citation of document, with indication, where appropriate, of the relevant passages | Relevant to claim No. |
| A | US 2019053095 A1 (HUAWEI TECHNOLOGIES CO., LTD.) 14 February 2019 (2019-02-14)<br>entire document | 1-22 |

Form PCT/ISA/210 (second sheet) (July 2022)

## INTERNATIONAL SEARCH REPORT
### Information on patent family members

International application No.

**PCT/CN2023/076267**

| Patent document cited in search report | | | Publication date (day/month/year) | Patent family member(s) | | | Publication date (day/month/year) |
|---|---|---|---|---|---|---|---|
| CN | 109525360 | A | 26 March 2019 | US | 2020220648 | A1 | 09 July 2020 |
| | | | | US | 10958374 | B2 | 23 March 2021 |
| | | | | US | 2021184786 | A1 | 17 June 2021 |
| | | | | US | 11362760 | B2 | 14 June 2022 |
| | | | | WO | 2019052583 | A1 | 21 March 2019 |
| | | | | EP | 3667927 | A1 | 17 June 2020 |
| | | | | EP | 3667927 | A4 | 09 September 2020 |
| | | | | CN | 109525360 | B | 16 October 2020 |
| CN | 106603084 | A | 26 April 2017 | None | | | |
| CN | 107342846 | A | 10 November 2017 | WO | 2019001447 | A1 | 03 January 2019 |
| | | | | EP | 3484077 | A1 | 15 May 2019 |
| | | | | EP | 3484077 | A4 | 25 December 2019 |
| | | | | EP | 3484077 | B1 | 17 March 2021 |
| | | | | BR | 112019008366 | A2 | 01 October 2019 |
| | | | | US | 2020274553 | A1 | 27 August 2020 |
| | | | | US | 11133829 | B2 | 28 September 2021 |
| | | | | US | 2019260392 | A1 | 22 August 2019 |
| | | | | US | 10581463 | B2 | 03 March 2020 |
| | | | | JP | 2020500490 | A | 09 January 2020 |
| | | | | JP | 6859444 | B2 | 14 April 2021 |
| | | | | VN | 66470 | A | 25 October 2019 |
| | | | | ID | 201905883 | A | 09 August 2019 |
| | | | | IN | 201917008354 | A | 03 January 2020 |
| CN | 107359967 | A | 17 November 2017 | None | | | |
| CN | 107425941 | A | 01 December 2017 | AU | 2018285297 | A1 | 30 January 2020 |
| | | | | AU | 2018285297 | B2 | 04 March 2021 |
| | | | | US | 2020266834 | A1 | 20 August 2020 |
| | | | | US | 11265018 | B2 | 01 March 2022 |
| | | | | US | 2019296769 | A1 | 26 September 2019 |
| | | | | US | 10608668 | B2 | 31 March 2020 |
| | | | | WO | 2018228591 | A1 | 20 December 2018 |
| | | | | JP | 2020523917 | A | 06 August 2020 |
| | | | | JP | 7026706 | B2 | 28 February 2022 |
| | | | | RU | 2020101281 | A | 16 July 2021 |
| | | | | RU | 2020101281 | A3 | 27 September 2021 |
| | | | | RU | 2768256 | C2 | 23 March 2022 |
| | | | | EP | 3584974 | A1 | 25 December 2019 |
| | | | | EP | 3584974 | A4 | 04 March 2020 |
| | | | | EP | 3584974 | B1 | 17 August 2022 |
| | | | | BR | 112019026657 | A2 | 23 June 2020 |
| | | | | KR | 20200016380 | A | 14 February 2020 |
| | | | | KR | 102287650 | B1 | 06 August 2021 |
| | | | | US | 2022123766 | A1 | 21 April 2022 |
| | | | | US | 11689220 | B2 | 27 June 2023 |
| CN | 110391874 | A | 29 October 2019 | WO | 2019206136 | A1 | 31 October 2019 |
| CN | 115173992 | A | 11 October 2022 | None | | | |
| US | 2019053095 | A1 | 14 February 2019 | EP | 3598674 | A1 | 22 January 2020 |
| | | | | EP | 3598674 | A4 | 25 March 2020 |
| | | | | US | 2020236589 | A1 | 23 July 2020 |

Form PCT/ISA/210 (patent family annex) (July 2022)

## INTERNATIONAL SEARCH REPORT
### Information on patent family members

International application No.

**PCT/CN2023/076267**

| Patent document cited in search report | Publication date (day/month/year) | Patent family member(s) | | | Publication date (day/month/year) |
|---|---|---|---|---|---|
| | | US | 11432186 | B2 | 30 August 2022 |
| | | BR | 112019020020 | A2 | 28 April 2020 |
| | | WO | 2018177227 | A1 | 04 October 2018 |
| | | JP | 2022174079 | A | 22 November 2022 |
| | | US | 2023056892 | A1 | 23 February 2023 |
| | | US | 11700545 | B2 | 11 July 2023 |
| | | US | 10440606 | B2 | 08 October 2019 |
| | | JP | 2020516157 | A | 28 May 2020 |
| | | US | 2019394674 | A1 | 26 December 2019 |
| | | US | 10567994 | B2 | 18 February 2020 |

Form PCT/ISA/210 (patent family annex) (July 2022)